(19) Europäisches Patentamt
European Patent Office
Office européen des brevets

(11) **EP 2 640 023 A1**

(12) **EUROPEAN PATENT APPLICATION**

(43) Date of publication:
**18.09.2013 Bulletin 2013/38**

(51) Int Cl.:
*H04L 25/02* [(2006.01)]     *H03K 19/0185* [(2006.01)]
*H03K 19/094* [(2006.01)]

(21) Application number: **12199638.3**

(22) Date of filing: **28.12.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **16.03.2012   JP 2012060178**

(71) Applicant: **FUJITSU LIMITED**
**Kawasaki-shi,**
**Kanagawa 211-8588 (JP)**

(72) Inventor: **Shirota, Shinichiro**
**Kanagawa, 211-8588 (JP)**

(74) Representative: **HOFFMANN EITLE**
**Patent- und Rechtsanwälte**
**Arabellastrasse 4**
**81925 München (DE)**

(54) **Transmission circuit for impedance matching**

(57)     A transmission circuit includes a first drive part capable of switching to one of an on state that is driven by current and an off state, i.e., a high impendance state in accordance the value of a first input signal; and a first termination resistor part connected in series with the first drive part. The resistance values of the first drive part are switched in accordance with the state of the first drive part.

FIG.4

EP 2 640 023 A1

## Description

FIELD

The embodiments discussed herein relates to a transmission circuit and, more particularly, to a current-driven-type transmission circuit that forms a high-speed interface circuit.

BACKGROUND

In a computer, such as a server and a personal computer, the amount of information to be processed increases and the processing speed is increased. As a result, it is necessary to increase the signal transfer speed in the transfer path connecting semiconductor devices forming an arithmetic processing device, a control device, and a storage device inside of an electronic computer. It is known to use a current-drive-type transmission circuit adopting the differential transfer scheme as a transmission circuit to transmit signals between semiconductor devices.

It is known that the current-driven-type transmission circuit includes a function for compensating for the loss of high-frequency components due to a parasitic capacitance, etc., within the transmission circuit and the loss of high-frequency components in the transfer path when the current-driven-type transmission circuit is used at a high signal transfer speed. It is possible to implement the function by increasing electric current flowing through the drive part of the transmission circuit during the rise time and fall time of the transfer signal. Further, it is also possible to implement the function by controlling the resistance value of the termination resistor in accordance with the bit rate. Furthermore, it is possible to implement the function by increasing the resistance value of the termination resistor at the time of rise and fall of the transfer signal.

Related Documents

[Patent Document 1] Japanese Laid Open Patent Document No. 2008-147940
[Patent Document 2] Japanese Laid Open Patent Document No. 2007-081608

SUMMARY

However, the on resistance of the termination resistor is lower and lower by downsizing semiconductor manufacturing process, and reducing the voltage of power source of the semiconductor device. As a result, the difference between the output impedances of on state and off state of driver is bigger and bigger. Thus, there is the problem that the difference causes the reflection at the boundary between a transmitter and a transfer.

According to a first aspect of the embodiment, a transmission circuit includes a first drive part capable of switching to one of an on state that is driven by current and an off state, i.e., a high impedance state in accordance the value of a first input signal; and a first termination resistor part connected in series with the first drive part. The resistance values of the first drive part are switched in accordance with the state of the first drive part.

BRIEF DESCRIPTION OF DRAWINGS

Fig. 1 is a circuit block diagram of a conventional transmission circuit;
Fig. 2 is a flowchart illustrating the operation of the transmission circuit illustrated in Fig. 1;
Fig. 3 is a circuit block diagram of a conventional transmission circuit;
Fig. 4 is a circuit block diagram of a transmission circuit of a first embodiment;
Fig. 5 is a circuit block diagram of an adjustment resistor part of the transmission circuit illustrated in Fig. 4;
Fig. 6 is a flowchart illustrating the operation of the transmission circuit illustrated in Fig. 4;
Fig. 7 is a circuit block diagram illustrating an operation state of the transmission circuit illustrated in Fig. 4;
Fig. 8 is a circuit block diagram illustrating another operation state of the transmission circuit illustrated in Fig. 4;
Fig. 9 is a circuit block diagram of a semiconductor device that mounts a transmission circuit of a second embodiment;
Fig. 10 is a circuit block diagram of the transmission circuit of the second embodiment;
Fig. 11A is a circuit block diagram of a variable adjustment resistor part of the transmission circuit illustrated in Fig. 10;
Fig. 11B is a circuit block diagram of a variable adjustment resistor part of the transmission circuit illustrated in Fig. 10;
Fig. 12A is a circuit block diagram of a variable base resistor part of the transmission circuit illustrated in Fig. 10;
Fig. 12B is a circuit block diagram of a variable base resistor part of the transmission circuit illustrated in Fig. 10;
Fig. 13 is a flowchart illustrating a method for setting a resistor set value of the transmission circuit illustrated in Fig. 10;
Fig. 14 is a flowchart illustrating a method for determining a resistor set value of the variable adjustment resistor part of the transmission circuit illustrated in Fig. 10;
Fig. 15 is a flowchart illustrating a method for determining a resistor set value of the variable base resistor part of the transmission circuit illustrated in Fig. 10;

Fig. 16 is a circuit block diagram of a resistance value setting system for setting a resistance value of a transmission circuit of a third embodiment;

Fig. 17A is a circuit block diagram of a variable adjustment resistor part of the transmission circuit illustrated in Fig. 16;

Fig. 17B is a circuit block diagram of a variable adjustment resistor part of the transmission circuit illustrated in Fig. 16;

Fig. 18A is a circuit block diagram of a variable base resistor part of the transmission circuit illustrated in Fig. 16;

Fig. 18B is a circuit block diagram of a variable base resistor part of the transmission circuit illustrated in Fig. 16;

Fig. 19A is a circuit block diagram of a resistor measurement resistor part of the transmission circuit illustrated in Fig. 16;

Fig. 19B is a circuit block diagram of a resistor measurement resistor part of the transmission circuit illustrated in Fig. 16;

Fig. 20 is a circuit block diagram of the resistor measurement resistor part of the transmission circuit illustrated in Fig. 16;

Fig. 21 is a flowchart illustrating a method for setting a resistor set value of the transmission circuit illustrated in Fig. 16;

Fig. 22 is a flowchart illustrating a method for setting a resistor set value of the variable adjustment resistor part of the transmission circuit illustrated in Fig. 16;

Fig. 23 is a flowchart illustrating a method for setting a resistor set value of the variable base resistor part of the transmission circuit illustrated in Fig. 16;

Fig. 24 is a circuit block diagram of a transmission circuit of a fourth embodiment;

Fig. 25 is a circuit block diagram of a transmission circuit of a fifth embodiment;

Fig. 26 is a circuit block diagram of a transmission circuit of a sixth embodiment;

Fig. 27 is a circuit block diagram of a transmission circuit of a seventh embodiment; and

Fig. 28 is a circuit block diagram of a transmission circuit of an eighth embodiment.

DESCRIPTION OF EMBODIMENTS

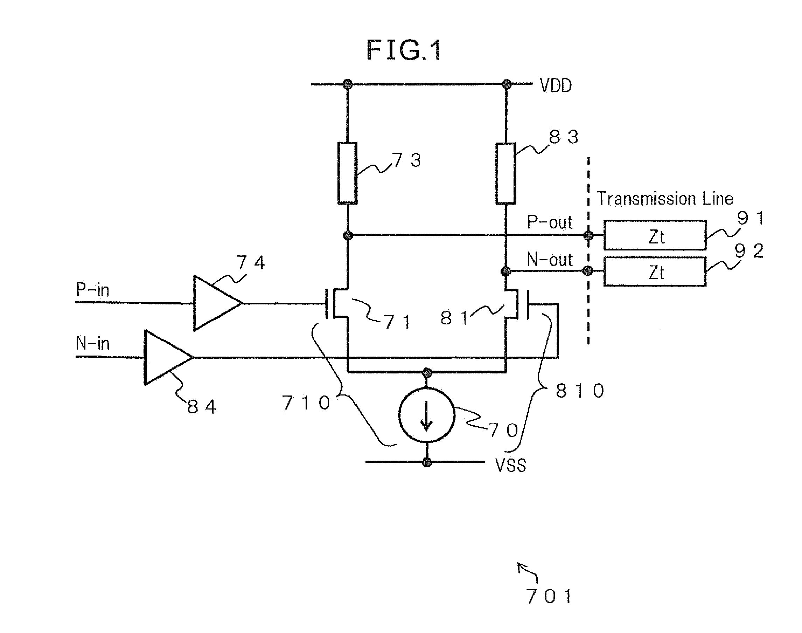

Before explaining a transmission circuit, a conventional current-driven-type transmission circuit is explained with reference to Figs. 1 to 3.

Fig. 1 is a diagram illustrating a conventional CML (Current Mode Logic) type transmission circuit.

A CML type transmission circuit 701 has a first current source 70, first and second transistors 71 and 81, first and second termination resistor parts 73 and 83, and fist and second buffers 74 and 84.

The first current source 70 has a MOS transistor and by applying an appropriate bias to the MOS transistor, the first current source 70 functions as a constant current source. One end of the first current source 70 is connected to VSS and the other end is connected to the sources of the first and second transistors 71 and 81, respectively.

The first and second transistors 71 and 81 have an n-type MOS transistor, respectively, and function as a switch. The gate of the first transistor 71 is connected to the output terminal of the first buffer 74 and the source is connected to the first current source 70. The drain of the first transistor 71 forms a first output terminal P-out connected to one end of a transfer path 91 and to one end of the first termination resistor part 73. When a Low signal is applied to the gate of the first transistor 71, the first transistor 71 enters the off state and has a high impedance when viewed from the transfer path 91. That is, when a Low signal is applied to the gate of the first transistor 71, the first transistor 71 enters the high impedance state. When a High signal is applied to the gate of the first transistor 71, the first transistor 71 enters the on state and causes electric current from the first current source 70 to flow to the first output terminal P-out. The first transistor 71 forms a first drive part 710 together with the first current source 70.

The gate of the second transistor 81 is connected to the output terminal of the buffer 84 and the source is connected to the first current source 70. The drain of the second transistor 81 forms a second output terminal N-out connected to one end of a transfer path 92 and to one end of the second termination resistor part 83. When a Low signal is applied to the gate of the second transistor 81, the second transistor 81 enters the off state, and therefore, the high impedance state. When a High signal is applied to the gate of the second transistor 81, the second transistor 81 enters the on state and causes electric current from the first current source 70 to flow to the second output terminal N-out. The second transistor 81 forms a second drive part 810 together with the first current source 70.

The first and second termination resistor parts 73 and 83 each have a resistor formed by making use of a polysilicon resistor and having a predetermined resistance value $R_t$.

When the resistance values or impedances are said to be equal, it means not only the case where both values are quite the same but also the case where a difference between both values is of magnitude that causes reflection between a transmitter and a transfer path the level of which does not affect the data transfer rate.

One end of the first termination resistor part 73 is connected to the first output terminal P-out and the other end is connected to VDD. When the first transistor 71 enters the on state, electric current flows through the first termination resistor part 73 and the first output terminal P-out turns to the Low level. When the first transistor 71 enters the off state, no electric current flows through the first termination resistor part 73 and the first output terminal P-out turns to the High level.

One end of the second termination resistor part 83 is connected to the second output terminal N-out and the other end is connected to VDD. When the second transistor 81 enters the on state, electric current flows through the second termination resistor part 83 and the second output terminal N-out turns to the Low level. When the second transistor 81 enters the off state, no electric current flows through the second termination resistor part 83 and the second output terminal N-out turns to the High level.

The first and second buffers 74 and 84 respectively have a plurality of inverters connected in series and respectively output signals at the same level as the signals to be input to first and second input terminals P-in and N-in to the gates of the first and second transistors 71 and 81.

The CML type transmission circuit 701 provides a differential signal by causing the second transistor 81 to enter the off state when the first transistor 71 is in the on state and by causing the second transistor 81 to enter the on state when the first transistor 71 is in the off state. That is, by causing the second transistor 81 to enter the off state when the first transistor 71 is in the on state, the first output terminal P-out turns to the Low level and the second output terminal N-out turns to the High level. On the other hand, by causing the second transistor 81 to enter the on state when the first transistor 71 is in the off state, the first output terminal P-out turns to the High level and the second output terminal N-out turns to the Low level.

Conventionally, in the CML type transmission circuit 701, in order to prevent reflection from occurring in the transfer paths 91 and 92, the resistance value $R_t$ of the first and second termination resistor parts 73 and 83 is made equal to a characteristic impedance $Z_t$ of the transfer paths 91 and 92. That is, by setting a reflection coefficient $\Gamma$ expressed by Formula (1) to zero, reflection is prevented from occurring.

$$\Gamma = \left| \frac{Z_{out} - Z_t}{Z_{out} + Z_t} \right| \qquad (1)$$

When the first drive part 710 and a second drive part 810 are in the on state, respectively:

$$Z_{out} = \frac{R_m \cdot rd}{R_m + rd} \qquad (2)$$

$$rd = Gm_c \cdot Z_c \cdot Z_s \qquad (3)$$

When the first and second drive parts 710 and 810 are in the off state, respectively:

$$Z_{out} = R_m \qquad (4)$$

$\Gamma$ : Reflection coefficient
$Z_t$ : Characteristic impedance of the transfer paths 91 and 92
$Z_{out}$ : Output impedance of the first and second output terminals P-out and N-out
$R_m$ : Resistance value of the first and second termination resistor parts 73 and 83
$rd$ : On resistance of the first and second drive parts 710 and 810
$Gm_c$ : Interconductance of the first and second transistors 71 and 81
$Z_c$ : On resistance of the first and second transistors 71 and 81
$Z_s$ : Impedance of the first and second current sources 70 and 80

Conventionally, while the resistance values $R_m$ of the first and second termination resistor parts 73 and 83 are, for example, 50 Ω, respectively, the on resistances of the first and second drive parts 710 and 810 are 1, 000 Ω or more, respectively. As described above, the on resistances of the first and second drive parts 710 and 810 are very large compared to the resistance values $R_m$ of the first and second termination resistor parts 73 and 83, and therefore, it used to be possible to approximate Formula (2) as

$$Z_{out} \approx R_m \qquad (5)$$

As a result, it used to be possible to regard the reflection coefficient $\Gamma$ expressed by Formula (1) as zero whether or not the first and second drive parts 710 and 810 are in the on state or in the off state.

However, accompanying the miniaturization of the semiconductor manufacturing process and the reduction in the power source voltage of the semiconductor device, the on resistance $rd$ of the first and second drive part 710 or 810 reduces. That is, accompanying the miniaturization of the semiconductor manufacturing process, the voltage- current characteristic of the MOS transistor deteriorates and at the same time, accompanying the reduction in the voltage of the power source of the semiconductor device, the voltage between source and drain reduces, and thereby, the on resistance $rd$ reduces. As a result, it is no longer possible to ignore the effect of the on resistance rd in Formula (2) and it is no longer possible to approximate the output impedance $Z_{out}$ as Formula (5) . As a result, there has been the problem that the output impedances $Z_{out}$ of the first and second output terminals P- out and N- out differ depending on whether the first and second drive parts 710 and 810 are in the on state or in the off state.

This problem is explained using the output impedance of the first output terminal P-out when the resistance value $R_m$ of the first termination resistor part 73 is 500 Ω and the on resistance rd of the first drive part 710 is 200 Ω as an example.

An output impedance $Z_{outH}$ of the output terminal P-out when the first drive part 710 is in the on state is calculated as 40 Ω by substituting 50 Ω for $R_m$ of Formula (2) and 200 Q for $Z_{out}$. An output impedance $Z_{outL}$ of the output terminal P-out when the first drive part 710 is in the off state is calculated as 50 Ω by Formula (4). As described above, the difference in magnitude between the resistance value $R_m$ of the first termination resistor part 73 and the on resistance rd of the first drive part 710 becomes small compared to the conventional one, and therefore, the output impedance changes to 40 Ω or 50 Ω in accordance with the state of the first drive part 710.

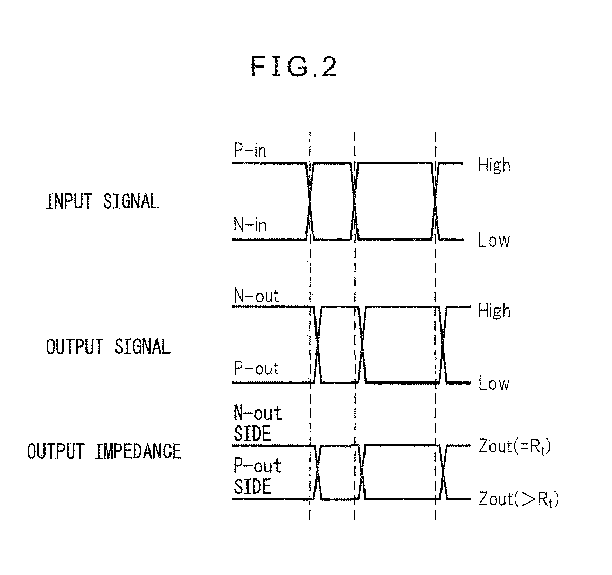

Fig. 2 is a diagram illustrating a timing chart of a conventional current-driven-type transmission circuit. A digital signal the amplitude of which is the potential difference between VDD and VSS is input to the first and second input terminals P-in and N-in, as an input signal and a differential voltage output to the first and second output terminals P-out and N-out in accordance with the input signal is output as an output signal.

The output impedance $Z_{out}$ of the first or second output terminal P-out or N-out changes in accordance with the output signal. When the signal level of the corresponding output terminal is the High level, the corresponding drive part is in the high impedance state, and therefore, the output impedance $Z_{out}$ is equal to the resistance value $R_m$ of the termination resistor as illustrated in Formula (4). On the other hand, when the signal level of the corresponding output terminal is the Low level, the on resistance value of the corresponding drive part is rd, and therefore, the output impedance $Z_{out}$ is smaller than the resistance value $R_m$ of the termination resistor as illustrated in Formula (2). As a result, when the resistance value $R_m$ of the termination resistor is made equal to the characteristic impedance $Z_t$ of the transfer path as conventionally, if the output terminal is at the High level, the numerator of Formula (1) is zero and the reflection coefficient $\Gamma$ is zero, and therefore, no reflection occurs between the transmission circuit and the transfer path. However, when the output terminal is at the High level, the output impedance $Z_{out}$ is smaller than the characteristic impedance $Z_t$ of the transfer path and the reflection coefficient $\Gamma$ expressed by Formula (1) is not zero, and therefore, reflection occurs between the transmission circuit and the transfer path.

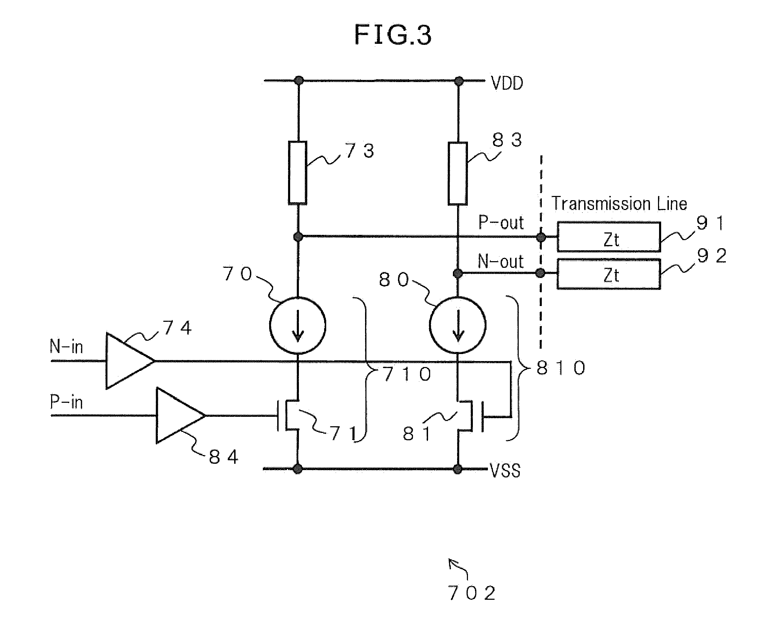

Fig. 3 is a diagram illustrating a CG (Common Gate)-type transmission circuit 702, which another conventional current-driven-type transmission circuit. The CG type transmission circuit 702 further has a second current source 80 having the same transistor as that of the first current source 70 and differs from the CML type transmission circuit 701 in that the first and second current sources 70 and 80 are connected to VSS via the first and second transistors 71 and 81, respectively.

The CG type transmission circuit 702 provides a differential signal by causing the second transistor 81 to enter the off state when the first transistor 71 is in the on state and by causing the second transistor 81 to enter the on state when the first transistor 71 is in the off state. The first drive part 710 is formed by the first current source 70 and the first transistor 71. The second drive unit 810 is formed by the second current source 80 and the second transistor 81.

In the CG type transmission circuit 702 also, when the on resistance rd of the first and second drive units 710 and 810 is not so large that Formula (2) can be approximated by Formula (5), the output impedance $Z_{out}$ varies in accordance with the state of the first and second transistors 71 and 81. As a result, even when the resistance value $R_m$ of the first and second termination resistor parts 73 and 83 is made equal to the characteristic impedance $Z_t$ of the transfer paths 91 and 92, reflection occurs when the first and second transistors 71 and 81 are in the on state.

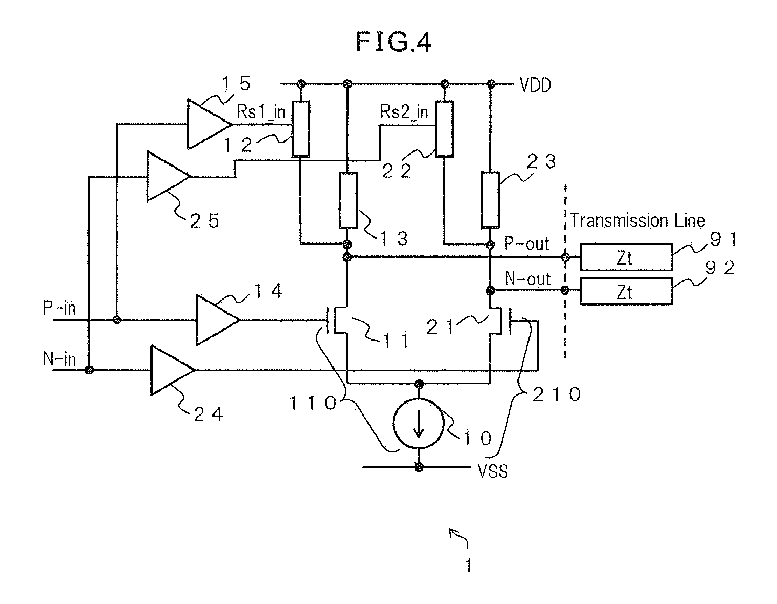

With reference to Figs. 4 to 8, a first embodiment is explained. Fig. 4 is a diagram illustrating a CML type transmission circuit 1.

The transmission circuit 1 has a first current source 10, first and second transistors 11 and 21, first and second adjustment resistor parts 12 and 22, first and second base resistor parts 13 and 23, and first to fourth buffers 14, 24, 15, and 25.

Each of the first current source 10, the first and second transistors 11 and 21, and the first and second buffers 14 and 24 has the same configuration and function as those of each of the first current source 70, the first and second transistors 71 and 81, and the first and second buffers 74 and 84.

The first transistor 11 forms a first drive part 110 together with the first current source 10. The second transistor 21 forms a second drive part 210 together with the first current source 70. The first adjustment resistor part 12 is connected in series with the first drive part 110 and the second adjustment resistor part 22 is connected in series with the second drive part 210. The first adjustment resistor part 12 and the first base resistor part 13 are connected in parallel and form a first termination resistor part. The second adjustment resistor part 22 and the second base resistor part 23 are connected in parallel and form a second termination resistor part.

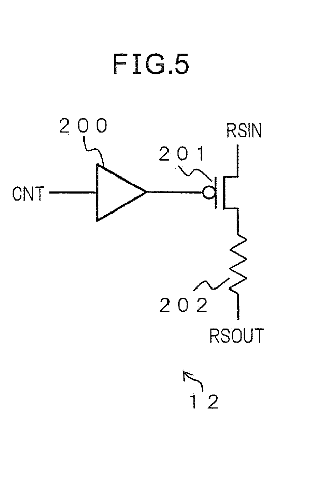

Fig. 5 is a circuit diagram of the first adjustment resistor part 12. The first adjustment resistor part 12 has a buffer 200, a transistor 201, and a resistor 202.

The buffer 200 outputs the non-inverted signal of a signal to be input to a CNT terminal to the gate of the transistor 201. The transistor 201 has a p-type MOS transistor and the gate is connected to the output of the buffer 200, the source is connected to an RSIN terminal, and the drain is connected to one end of the resistor 202. When a Low signal is input to the CNT terminal, the transistor 201 enters the on state and when a High signal is input to the CNT terminal, the transistor 201 enters the off state. One end of the resistor 202 is connected to the drain of the transistor 201 and the other end is connected to an RSOUT terminal. The resistor 202 of the first adjustment resistor part 12 is formed by making use of a polysilicon resistor and the resistance value of the resistor 202 of the first adjustment resistor part 12 and a resistance value $R_a$ between the RSIN terminal and the RSOUT terminal of the first adjustment resistor part 12 are made equal to the on resistance rd of the first drive part 110.

The second adjustment resistor part 22 has the same configuration as that of the first adjustment resistor part 12.

The first base resistor part 13 has a resistor formed by making use of a polysilicon resistor and the resistance value of which is $R_b$. The resistance value $R_b$ of the first base resistor part 13 is formed so that the combined resistance value when the first base resistor part 13 is connected in parallel with the first adjustment resistor part 12 is equal to the characteristic impedance $Z_t$ of the transfer path 91. Further, the resistance value $R_a$ of the first adjustment resistor part 12 and the on resistance rd of the first drive part 110 are equal, and therefore, the combined resistance value when the first base resistor part 13 is connected in parallel with the first drive part 110 is equal to the characteristic impedance $Z_t$ of the transfer path 91.

The second base resistor part 23 has a resistor the resistance value of which is $R_b$ as in the first base resistor part 13. The resistance value $R_b$ of the second base resistor part 23 is formed so that the combined resistance value when the second base resistor part 23 is connected in parallel with the second adjustment resistor part 22 is equal to the characteristic impedance $Z_t$ of the transfer path 92. Further, the resistance value $R_a$ of the second adjustment resistor part 22 and the on resistance rd of the second drive part 210 are equal, and therefore, the combined resistance value when the second base resistor part 23 is connected in parallel with the second drive part 210 is equal to the characteristic impedance $Z_t$ of the transfer path 92.

The third buffer 15 has a plurality of inverters connected in series and outputs a signal in the same phase as that of a signal to be input to the first input terminal P-in to the CNT terminal of the first adjustment resistor part 12 as a first control signal Rs1_in.

The fourth buffer 25 has a plurality of inverters connected in series and outputs a signal in the same phase as that of a signal to be input to the second input terminal N-in to the CNT terminal of the second adjustment resistor part 12 as a second control signal Rs2_in.

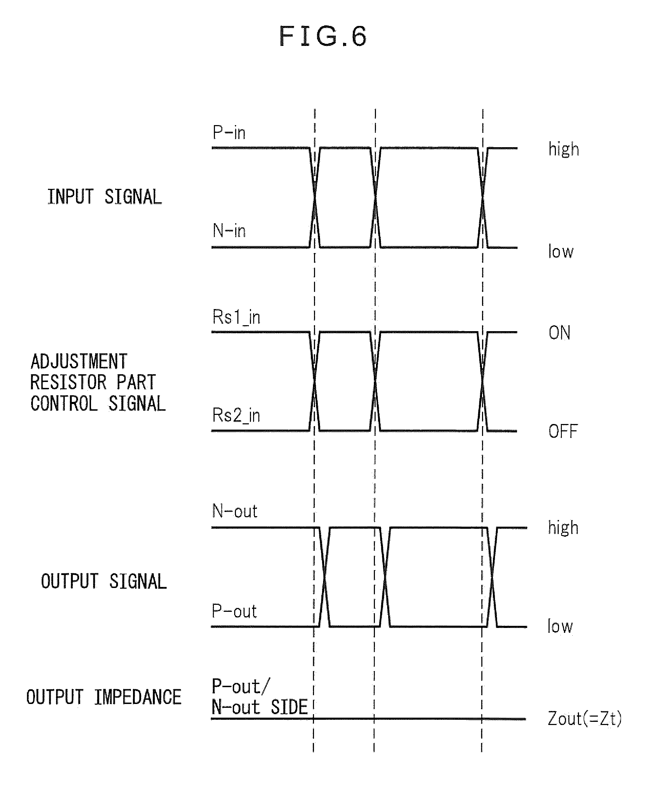

Fig. 6 is a diagram illustrating a timing chart corresponding to the operation of the transmission circuit 1.

When a High signal is input to the first input terminal P-in, a Low signal is input to the second input terminal N-in. On the other hand, when a Low signal is input to the first input terminal P-in, a High signal is input to the second input terminal N-in.

The first control signal Rs1_in to be input to the CNT terminal of the first adjustment resistor part 12 changes in accordance with a signal to be input to the first input terminal P-in. When a High signal is input to the first input terminal P-in, the first control signal Rs1_in turns to a High signal and when a Low signal is input to the first input terminal P-in, the first control signal Rs1_in turns to a Low signal.

The second control signal Rs2_in to be input to the CNT terminal of the second adjustment resistor part 22 changes in accordance with a signal to be input to the second input terminal N-in. When a High signal is input to the second input terminal N-in, the second control signal Rs2_in turns to a High signal and when a Low signal is input to the second input terminal N-in, the second control signal Rs2_in turns to a Low signal.

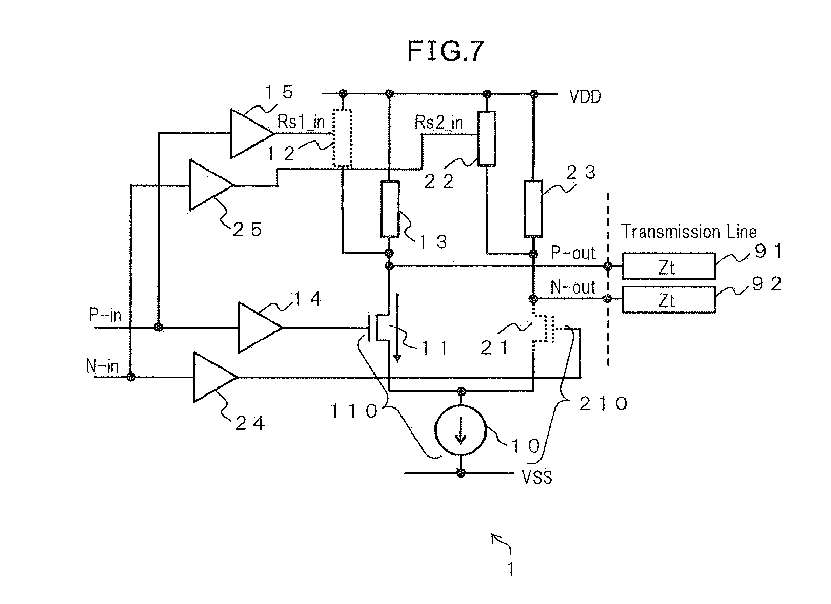

Fig. 7 is a diagram illustrating the transmission circuit 1 in the state where a High signal is input to the first input terminal P-in and a Low signal is input to the second input terminal N-in.

Since a High signal is input to the first input terminal P-in of the transmission circuit 1, the first transistor 11 enters the on state and the resistance value of the first drive part 110 when viewed from the first output terminal P-out becomes the on resistance rd. Further, the first control signal Rs1_in turns to a High signal, and therefore, the transistor 201 of the first adjustment resistor part 12 enters the off state. As a result, the resistance value of the first adjustment resistor part 12 when viewed from the first output terminal P-out becomes a high impedance. That is, when a High signal is input to the first input terminal P-in, the first adjustment resistor part 12 enters the high impedance state. As a result, an output impedance $Z_{outP}$ of the first output terminal P-out becomes the combined resistance value when the on resistance rd of the first drive part 110 and the resistance value $R_b$ of the first base resistor part 13 are connected in parallel. As described above, the combined resistance value when the on resistance rd of the first drive part 110 and the resistance value $R_b$ of the first base resistor part 13 are connected in parallel is equal to the characteristic impedance $Z_t$ of the transfer path, and therefore, the impedance $Z_{outP}$ is equal to the characteristic impedance $Z_t$ of the transfer path 91.

Since a Low signal is input to the second input terminal N-in of the transmission circuit 1, the second transistor 21 enters the off state and the second transistor 21 enters the high impedance state. Further, the second control signal Rs2_in turns to the Low level, and therefore, the transistor 201 of the second adjustment resistor part 22 enters the on state. As a result, the resistance value of the second adjustment resistor part 22 when viewed from the second output terminal N-out becomes $R_a$. As a result, an output impedance $Z_{outN}$ of the second output terminal N-out becomes the combined resistance value when the resistance value $R_a$ of the second adjustment resistor part 22 and the resistance value $R_b$ of the second base resistor part 23 are connected in parallel. As described above, the combined resistance value when the resistance value $R_a$ of the second adjustment resistor part 22 and the resistance value $R_b$ of the second base resistor part 23 are connected in parallel is equal to the characteristic impedance $Z_t$ of the transfer path, and therefore, the output impedance $Z_{outN}$ is equal to the characteristic impedance $Z_t$ of the transfer path 92.

In the state illustrated in Fig. 7, each of the output impedances $Z_{outP}$ and $Z_{outN}$ of the first and second output terminals P-out and N-out becomes equal to the characteristic impedance $Z_t$ of each of the transfer paths 91 and 92. Consequently, in the state where a High signal is input to the first input terminal P-in and a Low signal is input to the second input terminal N-in, reflection does not occur at the boundary between the transmission circuit 1 and the transfer paths 91 and 92.

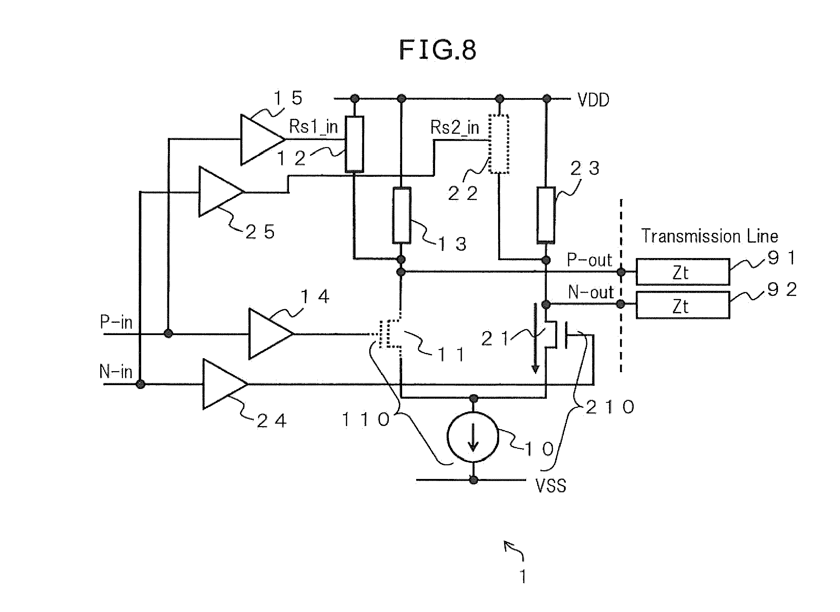

Fig. 8 is a diagram illustrating the transmission circuit 1 in the state where a Low signal is input to the first input terminal P-in and a High signal is input to the second input terminal N-in.

Since a Low signal is input to the first input terminal P-in of the transmission circuit 1, the first transistor 11 enters the off state and the first transistor 11 enters the high impedance state. Further, the first control signal Rs1_in turns to the Low level, and therefore, the transistor 201 of the first adjustment resistor part 12 enters the on state. As a result, the resistance value of the first adjustment resistor part 12 when viewed from the first output terminal P-out becomes $R_a$. As a result, the output impedance $Z_{outP}$ of the first output terminal P-out becomes the combined resistance value when the resistance value $R_a$ of the first adjustment resistor part 12 and the resistance value $R_b$ of the first base resistor part 13 are connected in parallel. As described above, the combined resistance value when the resistance value $R_a$ of the first adjustment resistor part 12 and the resistance value $R_b$ of the first base resistor part 13 is equal to the characteristic impedance $Z_t$ of the transfer path, and therefore, the impedance $Z_{outP}$ is equal to the characteristic impedance $Z_t$ of the transfer path 91.

Further, since a High signal is input to the second input terminal N-in of the transmission circuit 1, the second transistor 21 enters the on state and the resistance value of the second drive part 210 when viewed from the second output terminal N-out becomes the on resistance rd. Furthermore, the second control signal Rs2_in turns to a High signal, and therefore, the transistor 201 of the second adjustment resistor part 22 enters the off state. As a result, the second adjustment resistor part 22 enters the high impedance state. As a result, the output impedance $Z_{outN}$ of the second output terminal N-out becomes the combined resistance value when the on resistance rd of the second drive part 210 and the resistance value $R_b$ of the second base resistor part 23 are connected in parallel. As described above, the combined resistance value when the on resistance rd of the second drive part 210 and the resistance value $R_b$ of the second base resistor part 23 are connected in parallel is equal to the characteristic impedance $Z_t$ of the transfer path, and therefore, the impedance $Z_{outP}$ is equal to the characteristic impedance $Z_t$ of the transfer path 92.

In the state illustrated in Fig. 8, each of output impedances $Z_{outP2}$ and $Z_{outN2}$ of the first and second output terminal P-out and N-out is equal to the characteristic impedance $Z_t$ of the transfer paths 91 and 92. Consequently, in the state where a Low signal is input to the first input terminal P-in and a High signal is input to the second input terminal N-in, reflection does not occur at the boundary between the transmission circuit 1 and the transfer paths 91 and 92.

As above, the transmission circuit 1 is explained. In the transmission circuit 1, the resistance values of the first and second adjustment resistor parts 12 and 22 are switched respectively in accordance with the states of the first and second drive parts 110 and 210, and therefore, it is possible to make the output impedance of the transmission circuit 1 equal to the characteristic impedance of the transfer path. As a result, in the transmission circuit 1, reflection does not occur at the boundary between the transmission circuit 1 and the transfer paths 91 and 92.

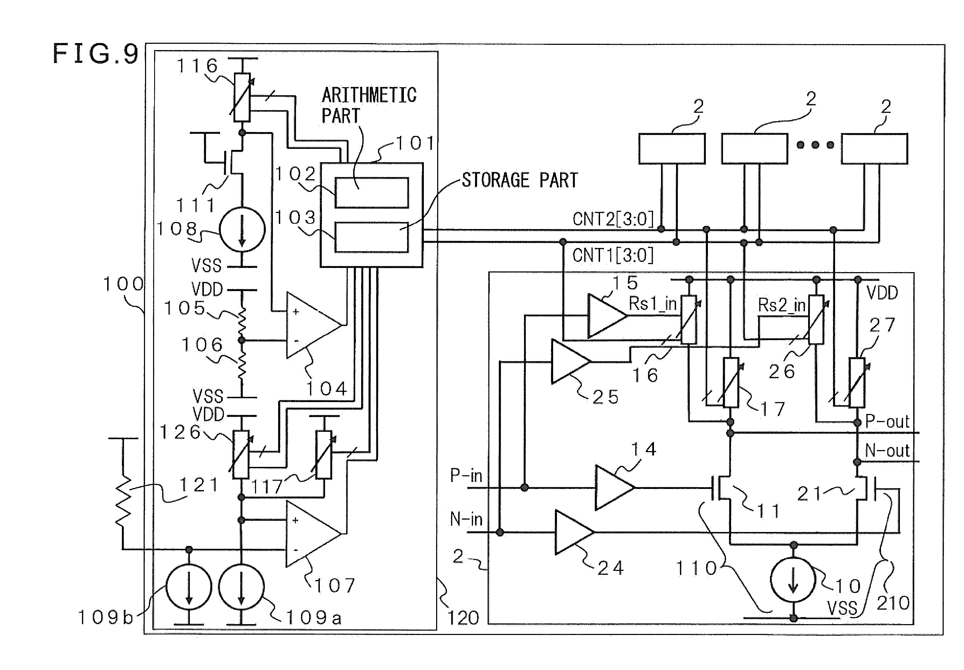

Next, with reference to Figs. 9 to 15, a second embodiment is explained.

Fig. 9 is a circuit block diagram of a semiconductor device 100. The semiconductor device 100 has a plurality of transmission circuits 2 and a variable resistor setting part 120.

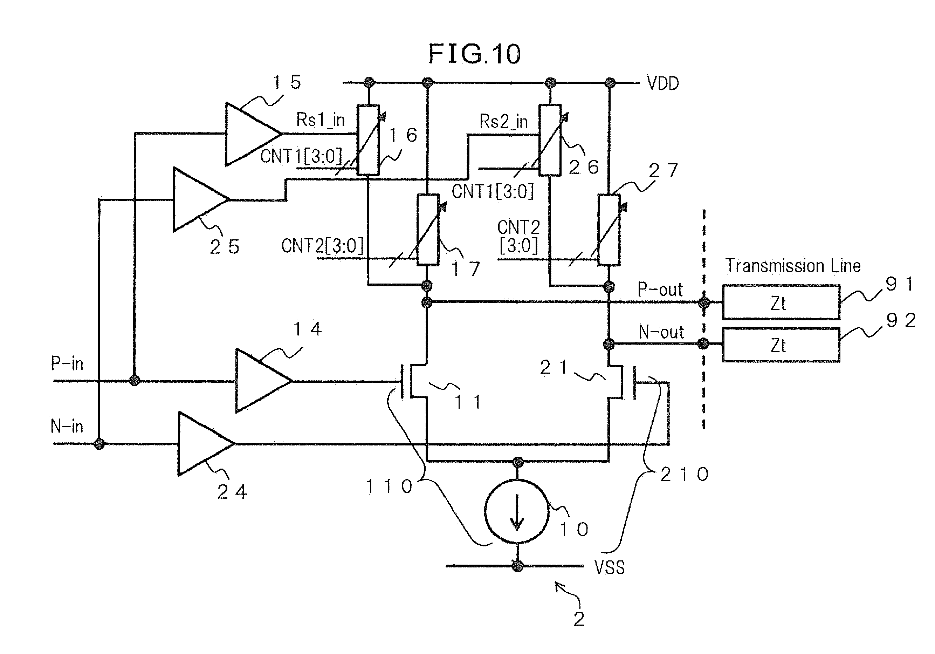

Fig. 10 is a diagram illustrating the transmission circuit 2. The transmission circuit 2 has the first current source 10, the first and second transistors 11 and 21, first and second variable adjustment resistor parts 16 and 26, first and second variable base resistor parts 17 and 27, and the first to fourth buffers 14, 24, 15, and 25. The transmission circuit 2 differs from the transmission circuit 1 explained previously in that the resistance values of the first and second variable adjustment resistor parts 16 and 26 and the first and second variable base resistor parts 17 and 27 are variable, respectively.

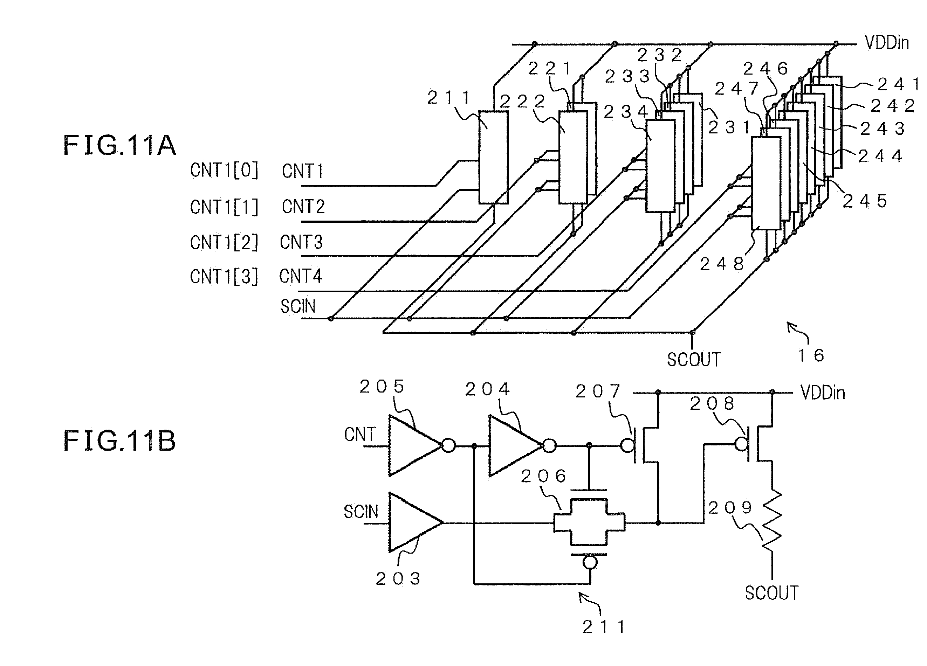

Fig. 11A is an internal circuit diagram of the first variable adjustment resistor part 16. Fig. 11B is an internal circuit diagram of an adjustment resistor unit 211.

The first variable adjustment resistor part 16 has a plurality of adjustment resistor units 211 to 248. VDDin terminals, SCIN terminals, and SCOUT terminals of the plurality of adjustment resistor units 211 to 248 are connected in common, respectively. A control first bit signal CNT1 [0] is input to the CNT terminal of the adjustment resistor unit 211 via a CNT1 terminal. A control second bit signal CNT1 [1] is input to the respective CNT terminals of the adjustment resistor units 221 and 22, via a CNT2 terminal. A control third bit signal CNT1 [2] is input to the respective CNT terminals of the adjustment resistor units 231 to 234 via a CNT3 terminal. A control fourth bit signal CNT1 [3] is input to the respective CNT terminals of the adjustment resistor units 241 to 248 via a CNT4 terminal.

The adjustment resistor unit 211 has a buffer 203, first and second inverters 204 and 205, a transfer gate 206, first and second transistors 207 and 208, and a resistor 209 formed by making use of a polysilicon resistor. The buffer 203 outputs the non-inverted signal of a signal input to the SCIN terminal to the transfer gate 206. The first and second inverters 204 and 205 output a signal input to the CNT terminal and the inverted signal of the signal input to the CNT terminal, respectively, to control the transfer gate 206 and the first transistor. When a Low signal is input to the CNT terminal, the transfer gate 206 does not allow the output signal of the buffer 203 to pass and the first transistor 207 enters the on state. Further, when a High signal is input to the CNT terminal, the transfer gate 206 allows the output signal of the buffer 203 to pass and the first transistor 207 enters the off state. The output terminal of the transfer gate 206 and the drain of the first transistor 207 are connected to the gate of the second transistor 208, and the second transistor 208 is controlled by signals to be input to the CNT terminal and the SCIN terminal, respectively. When a Low signal is input to the CNT terminal, the second transistor 208 enters the off state regardless of the signal input to the SCIN terminal. When a High signal is input to the CNT terminal, the state of the second transistor 208 is determined in accordance with the signal input to the SCIN terminal. When a High signal is input to the CNT terminal and a Low signal is input to the SCIN terminal, the second transistor 208 enters the on state. When a High signal is input to the CNT terminal and a High signal is input to the SCIN terminal, the second transistor 208 enters the off state.

The other adjustment resistor units 221 to 248 each have the same configuration and function as those of the adjustment resistor unit 211. The resistor value of the resistor 209 is formed so as to be the same in all of the adjustment resistor units 211 to 248.

It is possible to set the resistor value of the first variable adjustment resistor part 16 to a desired one by setting the value of a CNT1 [3 : 0] signal. For example, by setting the CNT1 [3 : 0] signal to [1001] the adjustment resistor unit 211 and the eight adjustment resistor units 241 to 248 are selected and it is possible to adjust the resistance value of the first variable adjustment resistor part 16 to a value 1/9 of the resistance value of the resistor 209. By setting the CNT1 [3 : 0] signal to [1010], the two adjustment resistor units 211 and 222 and the eight adjustment resistor units 241 to 248 are selected and it is possible to adjust the resistance value of the first variable adjustment resistor part 16 to a value 1/10 of the resistance value of the resistor 209. Further, by setting the CNT1 [3 : 0] signal to [1011], the adjustment resistor unit 211, the adjustment resistor units 221 and 222, and the adjustment resistor units 241 to 248 are selected. In this case, it is possible to adjust the resistance value of the first variable adjustment resistor part 16 to a value 1/11 of the resistance value of the resistor 209.

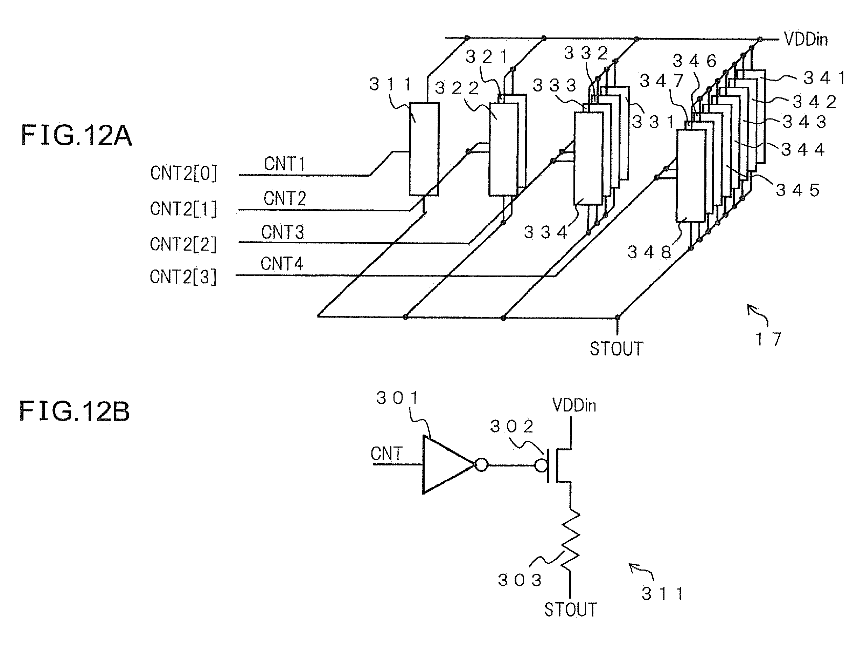

Fig. 12A is an internal circuit diagram of the first variable base resistor part 17. Fig. 12B is an internal circuit diagram of a base resistor unit 311.

The first variable base resistor part 17 has a plurality of base resistor units 311 to 348. The VDDin terminals, the SCIN terminals, and the SCOUT terminals of the plurality of base resistor units 311 to 348 are connected in common, respectively. A control first bit signal CNT2 [0] is input to the CNT terminal of the base resistor unit 311 via the CNT1 terminal. A control second bit signal CNT2 [1] is input to the respective CNT terminals of the base resistor units 321 and 322 via the CNT2 terminal. A control third bit signal CNT2 [2] is input to the respective CNT terminals of the base resistor units 331 to 334 via the CNT3 terminal. a control fourth bit signal CNT2 [3] is input to the respective CNT terminals of the base resistor units 341 to 348 via the CNT4 terminal.

The base resistor unit 311 has an inverter 301, a transistor 302, and a resistor 303 formed by making use of a polysilicon resistor. The inverter 301 inputs the inverted signal of a signal input to the CNT terminal to the gate of the transistor 302. When a High signal is input to the CNT terminal, the transistor 302 enters the on state and when a Low signal is input to the CNT terminal, the transistor enters the off state.

The other base resistor units 321 to 348 each have the same configuration and function as those of the base resistor unit 311. The resistance value of the resistor 303 is formed so as to be the same in all of the base resistor units 311 to 348.

The second variable adjustment resistor part 26 has the same configuration and function as those of the first variable adjustment resistor part 16. The second variable base resistor part 27 has the same configuration and function as those of the first variable base resistor part 17.

The variable resistor setting part 120 has a variable resistor setting control part 101, first and second comparators 104 and 107, first and second resistors 105 and 106, first to third current source 108, 109a, and 109b, and a transistor 111. The variable resistor setting part 120 further has an adjustment resistor setting resistor part 116, a base resistor setting resistor part 117, and a base resistor setting adjustment resistor part 126. The variable resistor setting part 120 functions so as to set the resistance values of the first and second variable adjustment resistor parts 16 and 26 and the first and second variable base resistor parts 17 and 27 of the plurality of transmission circuits 2 by detecting that the semiconductor device 100 is initialized.

The variable resistor setting control part 101 has an arithmetic part 12 and a storage part 103.

The arithmetic part 102 has a logic element forming a logic circuit and transmits a predetermined control signal to the adjustment resistor setting resistor part 116, the base resistor setting resistor part 117, and the base resistor setting adjustment resistor part 126 when the semiconductor device 100 is initialized. Then the arithmetic part 102 determines set values of the adjustment resistor setting resistor part 116 and the base resistor setting resistor part 117, respectively, and transmits the set values to the transmission circuit 2 when receiving a High signal from one of the first and second comparators 104 and 107.

The storage part 103 stores the resistor set value of each of the adjustment resistor setting resistor part 116 and the base resistor setting resistor part 117 that the arithmetic part 102 has determined and various kinds of data that the arithmetic part 102 uses.

The first and second comparators 104 and 107 each have a first input terminal indicated by [+] and a second input terminal indicated by [-]. The first and second comparators 104 and 107 are each formed so as to output a Low signal when the input voltage of the first input terminal is lower than the input voltage of the second input terminal and to output a High signal when the input voltage of the first input terminal is higher than the input voltage of the second input terminal.

The first input terminal of the first comparator 104 is connected between the adjustment resistor setting resistor part 116 and the serially connected transistor 111 and the first current source 108. The adjustment resistor setting resistor part 116 has the same configuration as that of the first and second variable adjustment resistor parts 16 and 26 of the transmission circuit 2.

The first current source 108 has the same configuration as that of the first current source 10 of the transmission circuit 2. The transistor 111 has the same configuration as that of the first and second transistors 11 and 22 of the transmission circuit 2 and the gate is connected to VDD. As a result, the resistance value of the circuit formed by the first current source 108 and the transistor 11 becomes the same as the on resistance of the first and second drive parts 110 and 210.

The second input terminal of the first comparator 104 is connected between the first resistor 105 and the second resistor 106. The first resistor 105 and the second resistor 106 have the same resistance value. As a result, to the second input terminal, a voltage 1/2 of VDD is applied.

When the resistance value of the adjustment resistor setting resistor part 116 is larger than the on resistance of the first and second drive parts 110 and 210, the input voltage of the first input terminal of the first comparator 104 is lower than 1/2 of VDD. On the other hand, when the resistance value of the adjustment resistor setting resistor part 116 is smaller than the on resistance of the first and second drive parts 110 and 210, the input voltage of the first input terminal of the first comparator 104 is higher than 1/2 of VDD. Consequently, by comparing the input voltage of the first input terminal and the input voltage of the second input terminal of the first comparator 104, whether or not the resistance value of the adjustment resistor setting resistor part 116 is larger than the on resistance of the first and second drive parts 110 and 210 is determined.

The first input terminal of the second comparator 107 is connected between the parallelly connected base resistor setting resistor part 117 and the base resistor setting adjustment resistor part 126, and the second current source 109a. The base resistor setting resistor part 117 has the same configuration as that of the first and second variable base resistor parts 17 and 27 of the transmission circuit 2. The base resistor setting adjustment resistor part 126 has the same configuration as that of the first variable adjustment resistor parts 16 and 26 of the transmission circuit 2. The second current source 109a is formed so as to generate a predetermined current.

The second input terminal of the second comparator 107 is connected between an external reference resistor 121 one end of which is connected to VDD and the third current source 109b. The external reference resistor 121 has the same resistance value as the characteristic impedance $Z_t$ of the transfer paths 91 and 92. The third current source 109b is formed so as to generate a current having the same current value as that of the second current source 109a.

When the combined resistance value of the base resistor setting resistor part 117 and the base resistor setting adjustment resistor part 126 is larger than the resistance value of the external reference resistor 121, the input voltage of the first input terminal of the first comparator 104 is lower than the input voltage of the second input terminal. On the other hand, when the combined resistance value of the base resistor setting resistor part 117 and the base resistor setting adjustment resistor part 126 is smaller than the resistance value of the external reference resistor 121, the input voltage of the first input terminal of the first comparator 104 is higher than the input terminal of the second input terminal. Consequently, by comparing the input voltage of the first input terminal and the input voltage of the second input terminal of the second comparator 107, whether or not the combined resistance value of the base resistor setting resistor part 117 and the base resistor setting adjustment resistor part 126 is larger than the resistance value of the external reference resistor 121 is determined.

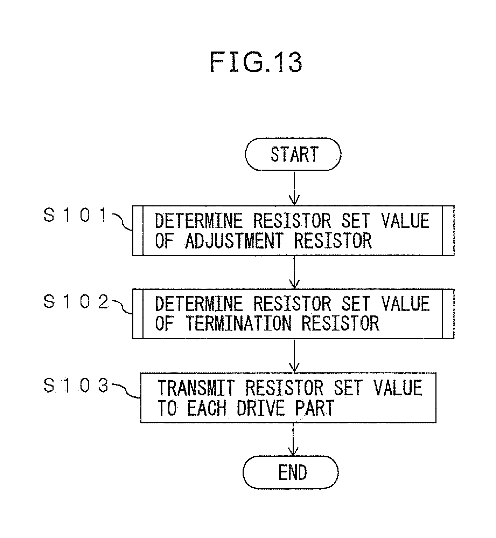

Fig. 13 is a diagram illustrating a flow by which the variable resistor setting control part 101 determines the set values of the adjustment resistor setting resistor part 116 and the base resistor setting resistor part 117, respectively.

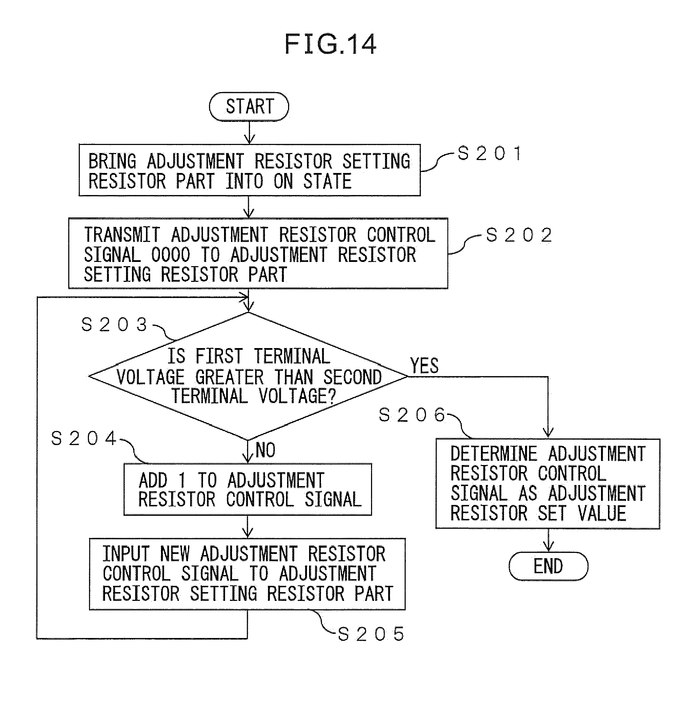

First, in step S101, the variable resistor setting control part 101 determines the resistor set value of the adjustment resistor setting resistor part 116. With reference to Fig. 14, processing of step S101 is explained in detail.

Fig. 14 is a diagram illustrating a flow to determine the resistor set value of the adjustment resistor setting resistor part 116.

First, in step S201, the variable resistor setting control part 101 detects that the semiconductor device 100 is initialized and brings the adjustment resistor setting resistor part 116 into the on state by transmitting a High signal to the SCIN terminal of the adjustment resistor setting resistor part 116.

Next, in step S202, the variable resistor setting control part 101 transmits [0000] as a control signal to the CNT1 to 4 terminals of the adjustment resistor setting resistor part 116. The variable resistor setting control part 101 stores the transmitted [0000] in the storage part 103 as an adjustment resistor control signal. When receiving [0000] as a control signal, the adjustment resistor setting resistor part 116 enters the high impedance state, and therefore, the input voltage of the first input terminal of the first comparator 104 becomes VSS.

Next, in step S203, the variable resistor setting control part 101 determines whether or not the voltage of the first input terminal of the first comparator 104 is higher than the voltage of the second input terminal based on the signal transmitted from the first comparator 104. When the variable resistor setting control part 101 transmits [0000] as a control signal to the adjustment resistor setting resistor part 116, the voltage of the first input terminal of the first comparator 104 is VSS. On the other hand, the voltage of the first input terminal of the first comparator 104 is 1/2 of VDD. Consequently, the first comparator 104 transmits a Low signal to the variable resistor setting control part 101 since the input voltage of the first input terminal is lower than the input voltage of the second input terminal. The variable resistor setting control part 101 having received the Low signal from the first comparator 104 determines that the voltage of the first input terminal of the first comparator 104 is lower than the voltage of the second input terminal and the processing proceeds to step S204.

Next, in step S204, the variable resistor setting control part 101 adds 1 to the adjustment resistor control signal stored in the storage part 103. Here, in the storage part 103, [0000] is stored as the adjustment resistor control signal, and therefore, the adjustment resistor control signal is newly stored in the storage part 103 as [0001] by the processing of step S203.

Next, in step S205, the variable resistor setting control part 101 transmits [0001] as a control signal to the adjustment resistor setting resistor part 116. When the adjustment resistor setting resistor part 116 receives [0001] as a control signal, only the adjustment resistor unit 211 of the adjustment resistor setting resistor part 116 is selected, and therefore, the resistance value of the adjustment resistor setting resistor part 116 becomes the same as the resistance value of the resistor 209. The processing returns to step S203.

Next, in step S203, the variable resistor setting control part 101 determines whether or not the voltage of the first input terminal of the first comparator 104 is higher than the voltage of the second input terminal based on the signal transmitted from the first comparator 104.

Until the variable resistor setting control part 101 determines that the voltage of the first input terminal of the first comparator 104 is greater than the voltage of the second input terminal, the processing of steps S203 to S205 is performed sequentially.

Then, in step S203, when a High signal is transmitted to the variable resistor setting control part 101 from the first comparator 104, the processing proceeds to step S206.

Then, in step S206, the variable resistor setting control part 101 stores the signal to be stored in the storage part 103 as the adjustment resistor control signal as the adjustment resistor set value.

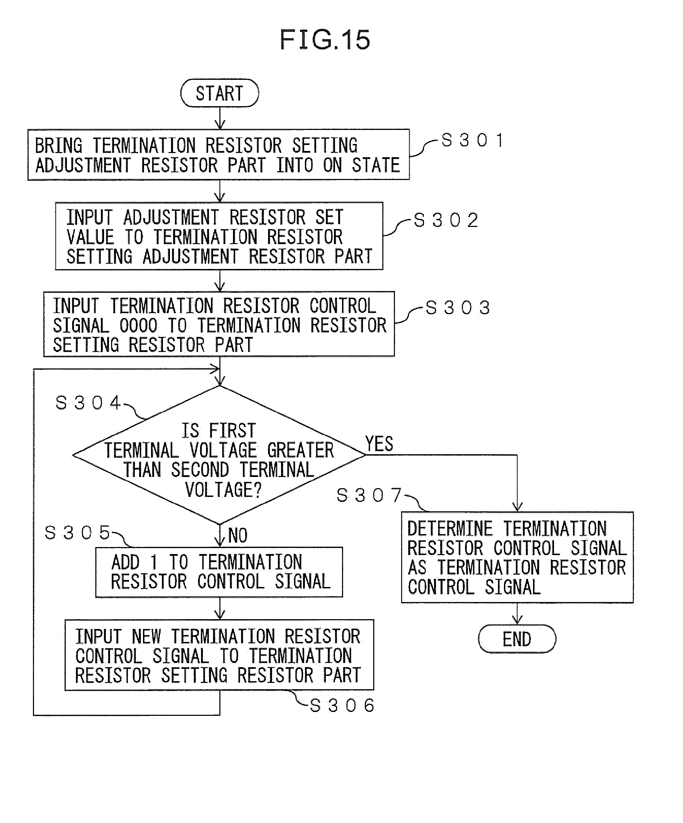

Next, in step S102, the variable resistor setting control part 101 determines the resistor set value of the base resistor setting resistor part 117. With reference to Fig. 15, the processing of step S102 is explained in detail.

Fig. 15 is a diagram illustrating a flow to determine the resistor set value of the base resistor setting resistor part 117.

First, in step S301, the variable resistor setting control part 101 transmits a High signal to the SCIN terminal of the base resistor setting adjustment resistor part 126 to bring the base resistor setting adjustment resistor part 126 into the on state.

Next, in step S302, the variable resistor setting control part 101 transmits the adjustment resistor set value determined in step S101 as a control signal to the CNT 1 to 4 terminals of the base resistor setting adjustment resistor part 126. As a result, the resistance value of the base resistor setting adjustment resistor part 126 becomes the same as the resistance value of the adjustment resistor setting resistor part 116 set in step S101.

Next, in step S303, the variable resistor setting control part 101 transmits [0000] as a control signal to the CNT1 to 4 terminals of the base resistor setting resistor part 117. The variable resistor setting control part 101 stores the transmitted [0000] in the storage part 103 as the base resistor control signal. When receiving [0000] as a control signal, the base resistor setting resistor part 117 enters the high impedance state.

Next, in step S304, the variable resistor setting control part 101 determines whether or not the voltage of the first input terminal of the second comparator 107 is greater than the voltage of the second input terminal based on the signal transmitted from the second comparator 107. The voltage of the second input terminal of the second comparator 107 is a voltage dropped from VDD by the voltage corresponding to the resistance value of the external reference resistor 121. On the other hand, when the variable resistor setting control part 101 transmits [0000] as a control signal to the base resistor setting resistor part 117, the voltage of the first input terminal of the second comparator 117 is a voltage dropped from VDD by the voltage corresponding to the resistance value of the base resistor setting adjustment resistor part 126. Consequently, the second comparator 107 transmits a Low signal to the variable resistor setting control part 101 since the input voltage of the first input terminal is lower than the input voltage of the second input terminal. The variable resistor setting control part 101 having received the Low signal from the second comparator 107 determines that the voltage of the first input terminal of the second comparator 107 is not greater than the voltage of the second input terminal and the processing proceeds to step S305.

Next, in step S305, the variable resistor setting control part 101 adds 1 to the adjustment resistor control signal stored in the storage part 103. Here, in the storage part 103, [0000] is stored as the base resistor control signal, and therefore, the base resistor control signal is newly stored in the storage part 103 as [0001] by the processing of step S304.

Next, in step S306, the variable resistor setting control part 101 transmits [0001] as a control signal to the base resistor setting resistor part 117. The processing returns to step S304.

Next, in step S304, the variable resistor setting control part 101 determines whether or not the voltage of the first input terminal of the second comparator 107 is greater than the voltage of the second input terminal based on the signal transmitted from the second comparator 107.

Until the variable resistor setting control part 101 determines that the voltage of the first input terminal of the second comparator107 is greater than the voltage of the second terminal, the processing of steps S304 to S306 is performed sequentially.

Then, in step S304, when a High signal is transmitted to the variable resistor setting control part 101 from the second comparator107, the processing proceeds to step S307.

Then, in step S307, the variable resistor setting control part 101 stores a signal to be stored as the base resistor control signal in the storage part 103 as the base resistor set value.

Next, in step S103, the variable resistor setting control part 101 transmits all the adjustment resistor set values and the base resistor set values stored in the storage part 103 to the transmission circuit 2. The adjustment resistor set value is transmitted as CNT1 [3 : 0] to the first and second variable adjustment resistor parts 16 and 26 of the transmission circuit 2. The base resistor set value is transmitted as CNT2 [3 : 0] to the first and second variable base resistor parts 17 and 27.

As a result, the resistance value of the first and second variable adjustment resistor parts 16 and 26 of the transmission circuit 2 becomes equal to the on resistance of the first and second drive parts 110 and 210. The output impedance of the transmission circuit 2, which is the combined resistance value of the first variable adjustment resistor part 16 and the first drive part 110 of the transmission circuit 2, becomes equal to the resistance value of the external reference resistor 121, that is, the characteristic impedance of the transfer paths 91 and 92.

As above, the transmission circuit 2, the variable resistor setting part 120 configured to set the resistance value of the variable resistor of the transmission circuit 2, and the semiconductor device 100 that mounts a plurality of the transmission circuits 2 are explained. The resistance value of the first and second variable adjustment resistor parts 16 and 26 of the transmission circuit 2 is adjusted so as to be equal to the on resistance of the first and second drive parts 110 and 120 by the variable resistor setting part 120 when the semiconductor device 100 is initialized. As a result, it is possible to adjust the output impedance to be a fixed value regardless of the manufacturing process condition and the operation condition, such as the operation temperature condition, of the semiconductor device 100.

Further, the resistance value of the first and second variable base resistor parts 17 and 27 of the transmission circuit 2 is adjusted by the variable resistor setting part 120 so that the combined resistance value of the first and second variable adjustment resistor parts 16 and 26 is equal to the characteristic impedance of the transfer paths 91 and 92. As a result, in the transmission circuit 2, it is possible to adjust the output impedance so as to prevent reflection from occurring at the boundary between the transmission circuit 2 and the transfer paths 91 and 92.

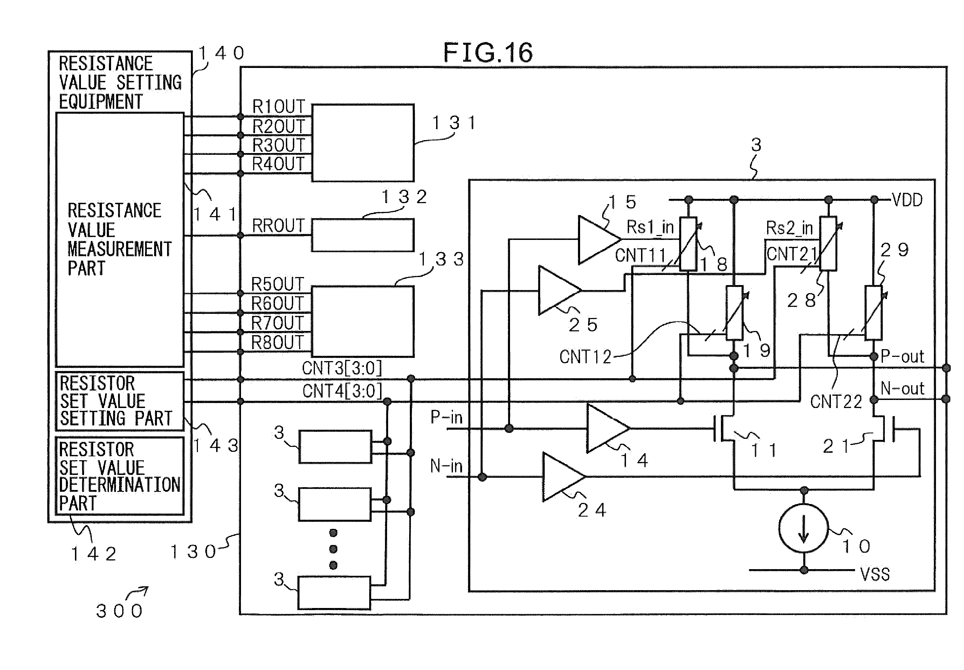

Next, with reference to Figs. 16 to 23, a third embodiment is explained.

Fig. 16 is a circuit block diagram of a resistance value setting system 300. The resistance value setting system 300 has a semiconductor device 130 and resistance value setting equipment 140 to be mounted on a semiconductor test device (not illustrated schematically).

The semiconductor device 130 has a plurality of transmission circuits 3, an adjustment resistor measurement resistor part 131, a drive part resistor measurement resistor part 132, and a base resistor measurement resistor part 133.

The transmission circuit 3 has the first current source 10, the first and second transistors 11 and 21, third and fourth variable adjustment resistor parts 18 and 28, third and fourth variable base resistor parts 19 and 29, and the first to fourth buffers 14, 24, 15, and 25. The transmission circuit 3 differs from the transmission circuit 1 explained previously in that it is possible to set the resistance value of the third and fourth variable adjustment resistor parts 18 and 28 and the third and fourth variable base resistor parts 19 and 29 by the resistance value setting equipment 140. The resistance value setting equipment 140 sets the resistance value of the third and fourth variable adjustment resistor parts 18 and 28 and the third and fourth variable base resistor parts 19 and 29 of the transmission circuit 3 at the time of test of the semiconductor device 130.

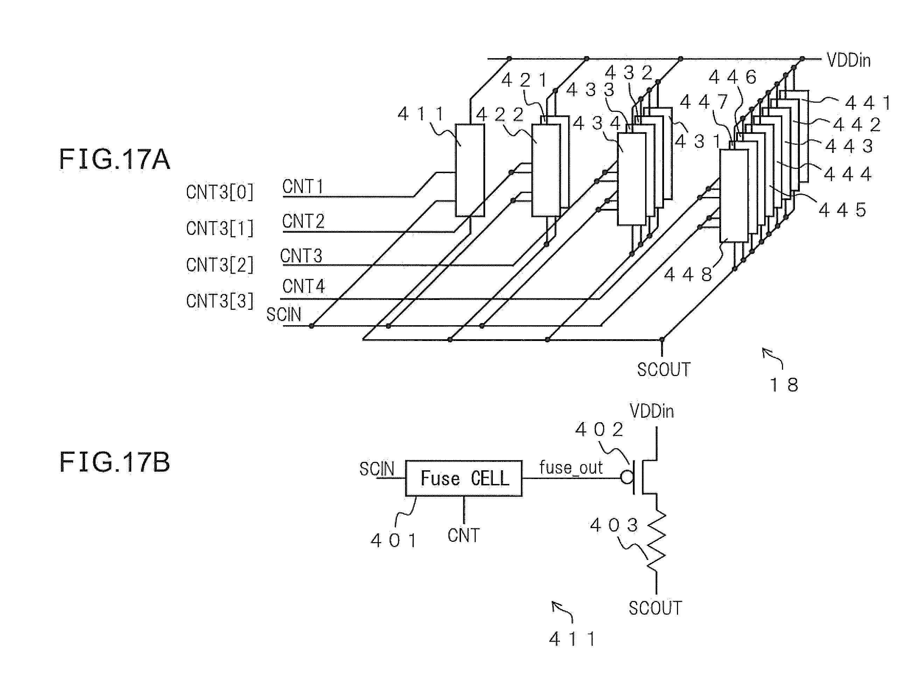

Fig. 17A is an internal circuit diagram of the third variable adjustment resistor part 18. Fig. 17B is an internal circuit diagram of an adjustment resistor setting unit 411.

The third variable adjustment resistor part 18 has a plurality of adjustment resistor setting units 411 to 448. The VDDin terminals, the SCIN terminals, and the SCOUT terminals of the plurality of the adjustment resistor setting units 411 to 448 are connected in common, respectively. A control first bit signal CNT3 [0] is input to the CNT terminal of the adjustment resistor setting unit 41 via the CNT1 terminal. A control second bit signal CNT3 [1] is input to the respective CNT terminals of the adjustment resistor setting units 421 and 422 via the CNT2 terminal. A control third bit signal CNT3 [2] is input to the respective CNT terminals of the adjustment resistor setting units 431 to 434 via the CNT3 terminal. A control fourth bit signal CNT3 [3] is input to the respective CNT terminals of the adjustment resistor setting units 441 to 448 via the CNT4 terminal.

The adjustment resistor setting unit 411 has a Fuse cell 401, a transistor 402, and a resistor 403 formed by making use of a polysilicon resistor. The Fuse cell 401 has a Fuse element and when the Fuse element is not fused, the Fuse cell 401 outputs the non-inverted signal of a signal input to the SCIN terminal as a fuse_out signal. Further, when the internal Fuse element is fused, the Fuse cell 401 outputs a High signal as the fuse_out signal. The Fuse element of the Fuse cell 401 is fused when a Low signal is applied to the CNT terminal for a predetermined period of time or more.

To the gate of the transistor 402, the fuse_out signal is input. When the internal Fuse element is not fused, the transistor 402 is controlled by the signal to be input to the SCIN terminal. When a High signal is input to the SCIN terminal when the internal Fuse element is not fused, the transistor 402 enters the off state. On the other hand, when a Low signal is input to the SCIN terminal when the internal Fuse element is not fused, the transistor 402 enters the on state. When the internal Fuse element is fused, a High signal is input to the gate of the transistor 402, and therefore, the transistor 402 enters the off state regardless of the signal to be input to the SCIN terminal.

The other adjustment resistor setting units 421 to 448 each have the same configuration and function as those of the adjustment resistor setting unit 411. The resistance value of the resistor 403 is formed so as to be the same in all of the adjustment resistor setting units 411 to 448.

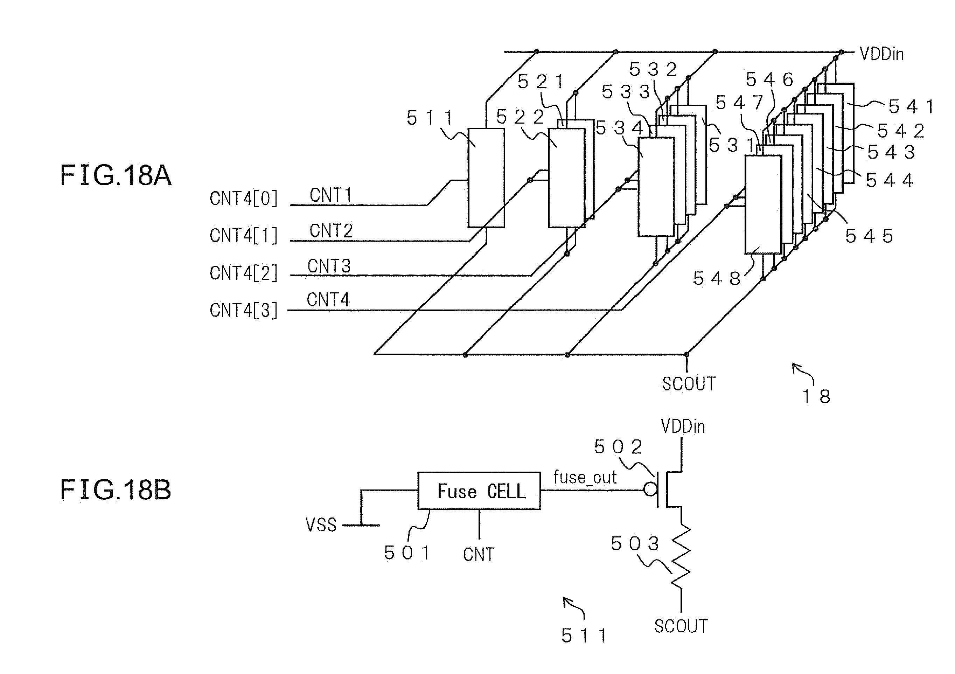

Fig. 18A is an internal circuit diagram of the third variable base resistor part 19. Fig. 18B is an internal circuit diagram of a base resistor setting unit 511.

The third variable base resistor part 19 has a plurality of base resistor setting units 511 to 548. The VDDin terminals, the SCIN terminals, and the SCOUT terminals of the plurality of the base resistor setting units 511 to 548 are connected in common, respectively. A control first bit signal CNT4 [0] is input to the CNT terminal of the base resistor setting unit 511 via the CNT1 terminal. A control second bit signal CNT4 [1] is input to the respective CNT terminals of the base resistor setting units 521 and 52 via the CNT2 terminal. A control third bit signal CNT4 [2] is input to the respective CNT terminals of the base resistor setting units 531 to 534 via the CNT3 terminal. a control fourth bit signal CNT4 [3] is input to the respective CNT terminals of the base resistor setting units 541 to 548 via the CNT4 terminal.

The base resistor setting unit 511 has a Fuse cell 501, a transistor 502, and a resistor 503 formed by making use of a polysilicon resistor. The Fuse cell 501 has a Fuse element the input terminal of which is connected to VSS. When the internal Fuse element is not fused, the Fuse cell 501 outputs a Low signal as the fuse_out signal and when the internal Fuse element is fused, the Fuse cell 501 outputs a High signal as the fuse_out signal. The Fuse element of the Fuse cell 501 is fused when a Low signal is applied to the CNT terminal for a predetermined period of time or more.

To the gate of the transistor 502, the fuse_out signal is input. When the internal Fuse element is not fused, the transistor 502 enters the on state. When the internal Fuse element is fused, the transistor 502 enters the off state.

The other base resistor setting units 521 to 548 each have the same configuration and function as those of the base resistor setting unit 511. The resistance value of the resistor 503 is formed so as to be the same in all of the base resistor setting units 511 to 548.

The fourth variable adjustment resistor part 28 has the same configuration and function as those of the third variable adjustment resistor part 18. The fourth variable base resistor part 29 has the same configuration and function as those of the third variable base resistor part 19.

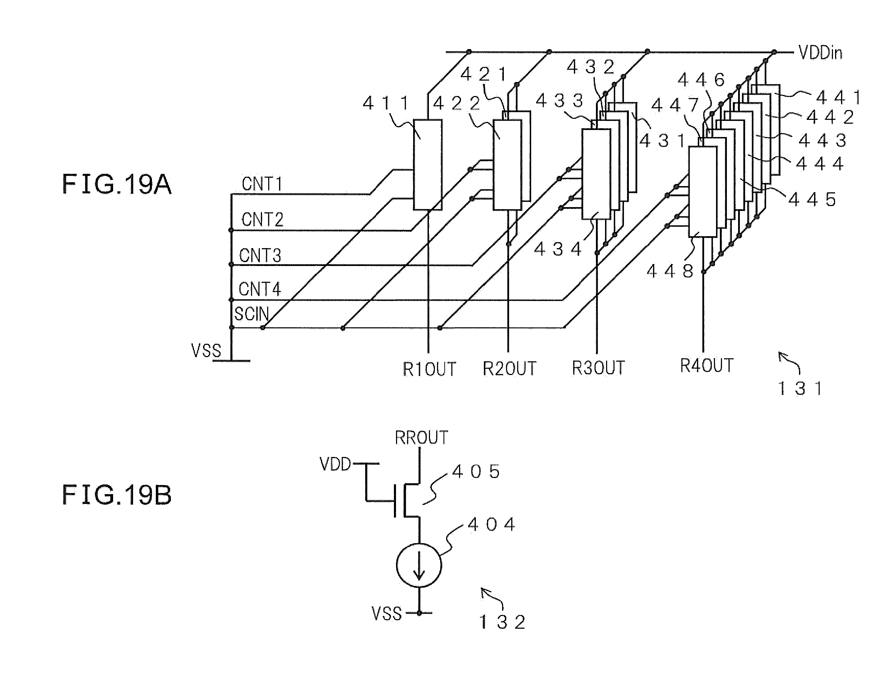

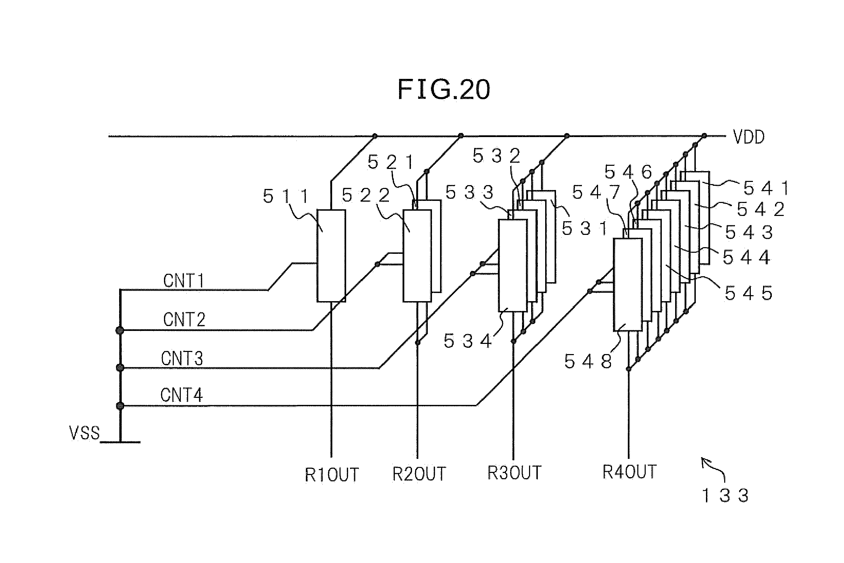

Fig. 19A is an internal circuit diagram of the adjustment resistor measurement resistor part 131. Fig. 19B is an internal circuit diagram of the drive part resistor measurement resistor part 132. Fig. 20 is an internal circuit diagram of the base resistor measurement resistor part 133.

The adjustment resistor measurement resistor part 131 has a plurality of the adjustment resistor setting units 411 to 448 and is used to set the resistance values of the internal resistors of the third and fourth variable adjustment resistor parts 18 and 28. The CNT1 to CNT4 terminals and the SCIN terminal connected to the CNT terminals of the adjustment resistor setting units 411 to 448, respectively, are connected to VSS. The SCOUT terminal of the adjustment resistor setting unit 411 is connected to an R1OUT terminal, which is an external connection terminal. The SCOUT terminals of the adjustment resistor setting units 421 and 422 are respectively connected to an R2OUT terminal, which is an external connection terminal. The SCOUT terminals of the adjustment resistor setting units 431 to 434 are respectively connected to an R3OUT terminal, which is an external connection terminal. The SCOUT terminals of the adjustment resistor setting units 441 to 448 are respectively connected to an R4OUT terminal, which is an external connection terminal.

The drive part resistor measurement resistor part 132 has a current source 404 and a transistor 405. The current source 404 has the same configuration as that of the first current source 10 of the transmission circuit 3. One end of the current source 404 is connected to the source of the transistor 405 and the other end is connected to VSS. The transistor 405 has the same configuration as that of the first and second transistors 11 and 22 of the transmission circuit 3 and the gate is connected to VDD and the drain is connected to an RROUT terminal, which is an external connection terminal. As a result, the resistance value of the circuit formed by the current source 404 and the transistor 405 becomes the same as the on resistance of the first and second drive parts 110 and 210.

The base resistor measurement resistor part 133 has a plurality of the base resistor setting units 511 to 548 and is used to set the resistance values of the internal resistors of the third and fourth variable base resistor parts 19 and 29. The CNT1 to CNT4 terminals connected to the CNT terminals of the base resistor setting units 511 to 548 respectively are connected to VSS. The SCOUT terminal of the base resistor setting unit 511 is connected to an R5OUT terminal, which is an external connection terminal. The SCOUT terminals of the base resistor setting units 521 and 522 are respectively connected to an R6OUT terminal, which is an external connection terminal. The SCOUT terminals of the base resistor setting units 531 to 534 are respectively connected to an R7OUT terminal, which is an external connection terminal. The SCOUT terminals of the base resistor setting units 541 to 548 are respectively connected to an R8OUT terminal, which is an external connection terminal.

The resistance value setting equipment 140 has a resistance value measurement part 141, a resistor set value determination part 142, and a resistor set value setting part 143.

The resistance value measurement part 141 measures the resistance values of circuits to be arranged in the adjustment resistor measurement resistor part 131, the drive part resistor measurement resistor part 132, and the base resistor measurement resistor part 133, respectively.

When the resistance value measurement part 141 measures the resistance value of the circuit to be arranged in the adjustment resistor measurement resistor part 131, the resistance value measurement part 141 turns the voltage level of the R1OUT terminal, the R2OUT terminal, the R3OUT terminal, and the R4OUT terminal to VSS. Next, the resistance value measurement part 141 measures the current value of the current flowing between the resistance value measurement part 141 and the adjustment resistor measurement resistor part 131. Then, the resistance value measurement part 141 calculates the resistance value of the adjustment resistor setting unit 411, the combined resistance value of the adjustment resistor setting units 421 and 422, the combined resistance value of the adjustment resistor setting units 431 to 434, and the combined resistance value of the adjustment resistor setting units 441 to 448, respectively.

When the resistance value measurement part 141 measures the resistance value of the circuit to be arranged in the drive part resistor measurement resistor part 132, the resistance value measurement part 141 turns the voltage level of the RROUT terminal to VDD. Then, the resistance value measurement part 141 calculates the combined resistance value of the current source 404 and the transistor 405 from the current value of the current flowing between the resistance value measurement part 141 and the drive part resistor measurement resistor part 132.

When the resistance value measurement part 141 measures the resistance value of the circuit to be arranged in the base resistor measurement resistor part 133, the resistance value measurement part 141 turns the voltage level of the R5OUT terminal, the R6OUT terminal, the R7OUT terminal, and the R8OUT terminal to VSS. Then, the resistance value measurement part 141 measures the current value of the current flowing between the resistance value measurement part 141 and the base resistor measurement resistor part 133. Then, the resistance value measurement part 141 calculates the resistance value of the base resistor setting unit 511, the combined resistance value of the base resistor setting units 521 and 522, the combined resistance value of the base resistor setting units 531 to 534, and the combined resistance value of the base resistor setting units 541 to 548, respectively.

The resistor set value determination part 142 determines the resistor set values of the third and fourth variable adjustment resistor parts 18 and 28 and the third and fourth variable base resistor parts 19 and 29. The resistor set value determination part 142 determines the resistor set values using the resistance values of the respective circuits in the adjustment resistor measurement resistor part 131, the drive part resistor measurement resistor part 132, and the base resistor measurement resistor part 133 measured by the resistance value measurement part 141.

The resistor set value setting part 143 outputs CNT3 [3 : 0] and CNT4 [3 : 0] that set the resistor set values of the third and fourth variable adjustment resistor parts 18 and 28 and the third and fourth variable base resistor parts 19 and 29 to the resistor set values determined by the resistor set value determination part 142. The Fuse elements of the Fuse cells 401 and 501 corresponding to the bits to which a Low signal is input in CNT3 [3 : 0] and CNT4 [3 : 0] are fused, respectively. The Fuse elements of the Fuse cells 401 and 501 corresponding to the bits to which a High signal is input are not fused and the on state and the off state are switched based on the signal input to the SCIN terminal.

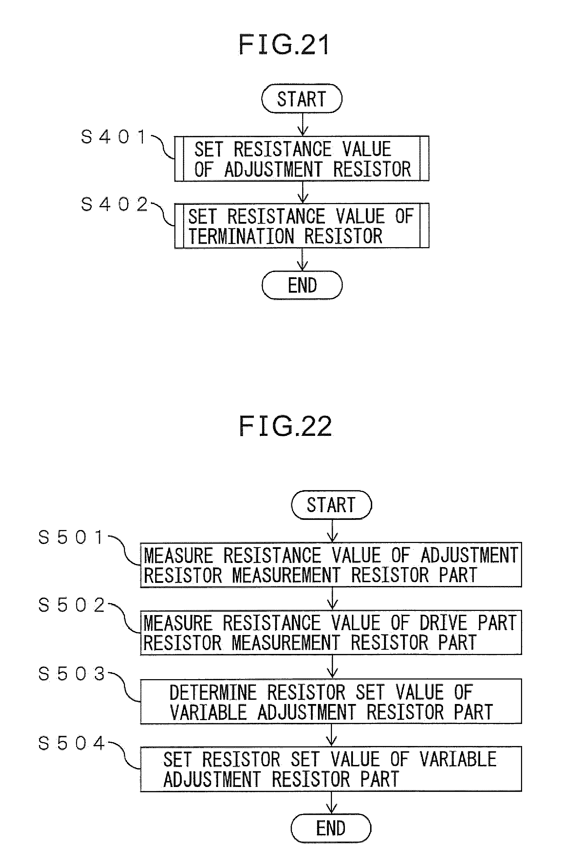

Fig. 21 is a diagram illustrating a flow to set the respective resistance values of the third and fourth variable adjustment resistor parts 18 and 28 and the third and fourth variable base resistor parts 19 and 29 of the transmission circuit 3 by the resistance value setting equipment 140.

First, in step S401, the resistance value setting equipment 140 sets the resistor set value of the third and fourth variable adjustment resistor parts 18 and 28. With reference to Fig. 22, processing of step S401 is explained in detail.

Fig. 22 is a diagram illustrating a flow to set the resistor set value of the third and fourth variable adjustment resistor parts 18 and 28.

First, in step S501, the resistance value measurement part 141 measures the resistance value of the circuit to be arranged in the adjustment resistor measurement resistor part 131. The measured resistance value is stored in the storage part inside of the resistor set value determination part 142.

Next, in step S502, the resistance value measurement part 141 measures the resistance value of the circuit to be arranged in the drive part resistor measurement resistor part 132. The measured resistance value is stored in the storage part inside of the resistor set value determination part 142.

Next, in step S503, the resistor set value determination part 142 determines the resistor set value of the third and fourth variable adjustment resistor parts 18 and 28 based on the resistance values measured in steps S501 and S502, respectively. The resistor set value determination part 142 determines the resistor set value so that the resistance value of the third and fourth variable adjustment resistor parts 18 and 28 becomes equal to the on resistance of the first and second drive parts 110 and 210.

Then, in step S504, the resistor set value setting part 143 transmits the resistor set value determined in step S503 to the third and fourth variable adjustment resistor parts 18 and 28 as the control signal CNT3 [3 : 0] . By the Fuse element of the Fuse cell 401 corresponding to the bit to which a Low signal is input in the control signal CNT3 [3 : 0] being fused, the resistance value of the third and fourth variable adjustment resistor parts 18 and 28 is set.

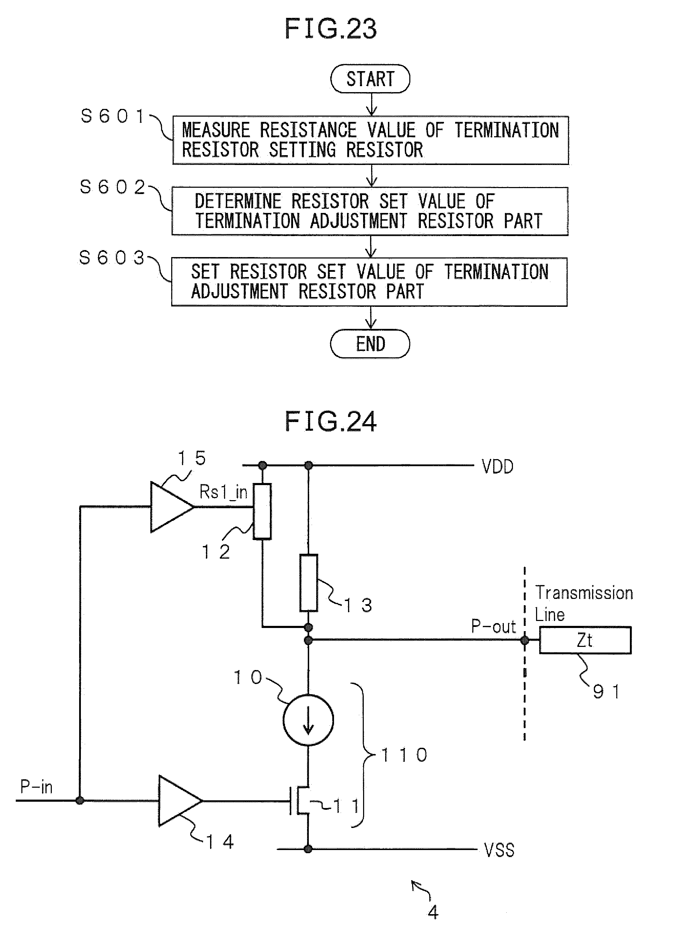

Next, in step S402, the resistance value setting equipment 140 sets the resistor set value of the third and fourth variable base resistor parts 19 and 29. With reference to Fig. 23, processing of step S402 is explained in detail.

Fig. 23 is a diagram illustrating a flow to set the resistor set value of the third and fourth variable base resistor parts 19 and 29.

First, in step S601, the resistance value measurement part 141 measures the resistance value of the circuit to be arranged in the base resistor measurement resistor part 133. The measured resistance value is stored in the storage part inside of the resistor set value determination part 142.

Next, in step S602, the resistor set value determination part 142 determines the resistor set value of the third and fourth variable base resistor parts 19 and 29. The resistance set value of the third and fourth variable base resistor parts 19 and 29 is determined based on the resistor set value of the third and fourth variable adjustment resistor parts 18 and 28 determined in step S503 and the resistance value measured in step S601. The resistor set value determination part 142 determines the resistor set value so that the combined resistance value of the third and fourth variable adjustment resistor parts 18 and 28 and the third and fourth variable base resistor parts 19 and 29 becomes a desired resistance value. For example, if the characteristic impedance of the transfer paths 91 and 92 is 50 $\Omega$, the resistor set value is determined so that the combined resistance value of the third and fourth variable adjustment resistor parts 18 and 28 and the third and fourth variable base resistor parts 19 and 29 becomes 50 $\Omega$.

Then, in step S603, the resistor set value setting part 143 transmits the resistor set value determined in step S602 to the third and fourth variable base resistor parts 19 and 29 as the control signal CNT4 [3 : 0] . By the Fuse element of the Fuse cell 501 corresponding to the bit to which a Low signal is input in the control signal CNT4 [3 : 0] being fused, the resistance value of the third and fourth variable base resistor parts 19 and 29 is set.

As above, the transmission circuit 3 and the resistance value setting system 300 that sets the resistance value of the variable resistor of the transmission circuit 3 are explained. The resistance value of the third and fourth variable adjustment resistor parts 18 and 28 of the transmission circuit 3 is set so as to become equal to the on resistance of the first and second drive parts 110 and 210 by the resistance value setting equipment 140. Further, the resistance value of the third and fourth variable base resistor parts 19 and 29 of the transmission circuit 3 is set so that the combined resistance value of the third and fourth variable adjustment resistor parts 18 and 28 becomes a desired resistance value by the resistance value setting equipment 140. As a result, in the transmission circuit 3, when the characteristic impedance of the transfer paths 91 and 92 is a desired resistance value, it is possible to set the resistance value so as to prevent reflection from occurring at the boundary between the transmission circuit 3 and the transfer paths 91 and 92 regardless of the manufacturing process condition of the semiconductor device 130.

With reference to Fig. 24, a fourth embodiment is explained. Fig. 24 is a diagram illustrating a transmission circuit 4.

The transmission circuit 4 has the first current source 10, the first transistor 11, the first adjustment resistor part 12, the first base resistor part 13, and the first and third buffers 14 and 15.

The transmission circuit 4 differs from the transmission circuit 1 explained previously in being a single end transfer circuit, not a differential transfer circuit. The resistance value of the first adjustment resistor part 12 is equal to the on resistance of the first drive part 110. The combined resistance value when the first adjustment resistor part 12 and the first base resistor part 13 are connected in parallel is equal to the characteristic impedance of the transfer path 91.

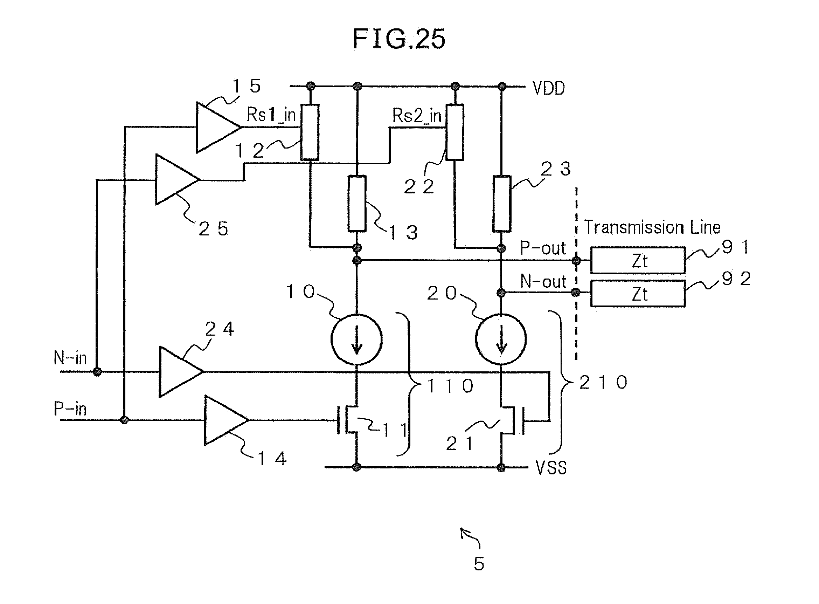

With reference to Fig. 25, a fifth embodiment is explained. Fig. 25 is a diagram illustrating a transmission circuit 5.

The transmission circuit 5 has the first current source 10 and a second current source 20, the first and second transistors 11 and 21, the first and second adjustment resistor parts 12 and 22, the first and second base resistor parts 13 and 23, and the first to fourth buffers 14, 24, 15, and 25.

The transmission circuit 5 differs from the transmission circuit 1 explained previously in being a CG-type transmission circuit, not a CML-type transmission circuit. The resistance value of the first adjustment resistor part 12 is equal to the on resistance of the first drive part 110. The combined resistance value when the first adjustment resistor part 12 and the first base resistor part 13 are connected in parallel is equal to the characteristic impedance of the transfer path 91. The resistance value of the second adjustment resistor part 22 is equal to the on resistance of the second drive part 210. The combined resistance value when the second adjustment resistor part 22 and the second base resistor part 23 are connected in parallel is equal to the characteristic impedance of the transfer path 92. the inverted signal of a signal to be applied to the P-in terminal is applied to the N-in terminal.

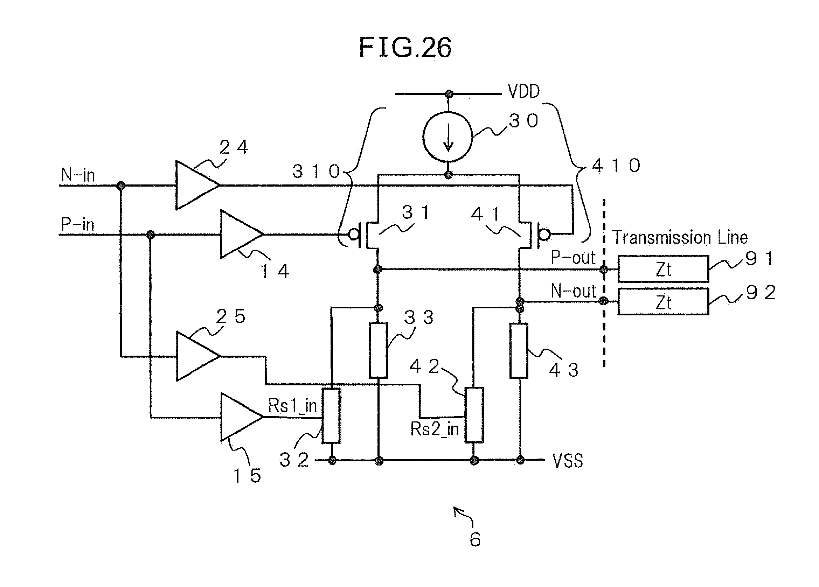

With reference to Fig. 26, a sixth embodiment is explained. Fig. 26 is a diagram illustrating a transmission circuit 6.

The transmission circuit 6 has a third current source 30, third and fourth transistors 31 and 41, third and fourth adjustment resistor parts 32 and 42, third and fourth base resistor parts 33 and 43, and the first to fourth buffers 14, 24, 15, and 25.

The transmission circuit 6 differs from the transmission 1 explained previously in that the third and fourth transistors 31 and 41 that function as a switch of third and fourth drive parts 310 and 410 is not an n-type transistor but a p-type transistor. The resistance value of the third adjustment resistor part 32 is equal to the on resistance of the third drive part 310. The combined resistance value when the third adjustment resistor part 32 and the third base resistor part 33 are connected in parallel is equal to the characteristic impedance of the transfer path 91. The resistance value of the fourth adjustment resistor part 42 is equal to the on resistance of the fourth drive part 410. The combined resistance value when the fourth adjustment resistor part 42 and the fourth base resistor part 43 are connected in parallel is equal to the characteristic impedance of the transfer path 92. The inverted signal of a signal to be applied to the P-in terminal is applied to the N-in terminal.

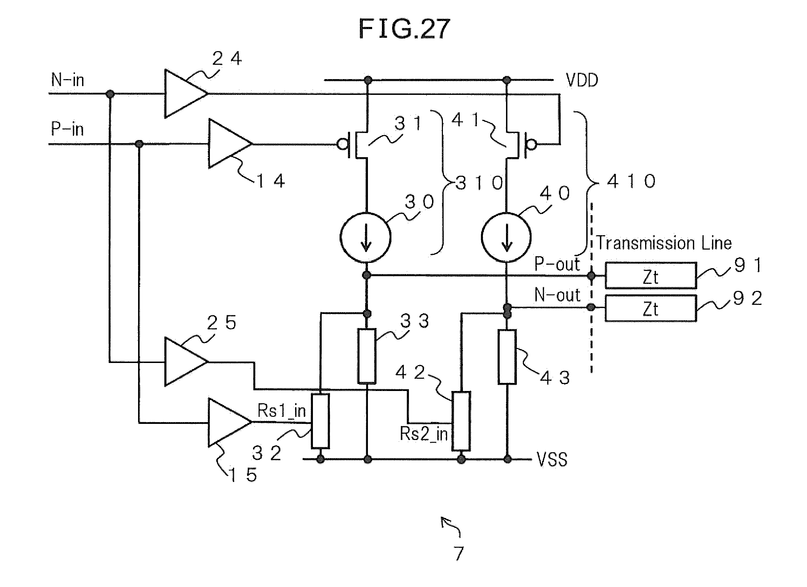

With reference to Fig. 27, a seventh embodiment is explained. Fig. 27 is a diagram illustrating a transmission circuit 7.

The transmission circuit 7 has the third current source 30 and a fourth current source 40, the third and fourth transistors 31 and 41, the third and fourth adjustment resistor parts 32 and 42, the third and fourth base resistor parts 33 and 43, and the first to fourth buffers 14, 24, 15, and 25.

The transmission circuit 7 differs from the transmission circuit 1 explained previously in being a CG type transmission circuit, not a CML type transmission circuit. Further, the transmission circuit 7 differs from the transmission circuit 1 explained previously in that the third and fourth transistors 31 and 41 that function as a switch of the third and fourth drive parts 310 and 410 is not an n-type transistor but a p-type transistor.

The resistance value of the third adjustment resistor part 32 is equal to the on resistance of the third drive part 310. The combined resistance value when the third adjustment resistor part 32 and the third base resistor part 33 are connected in parallel is equal to the characteristic impedance of the transfer path 91. The resistance value of the fourth adjustment resistor part 42 is equal to the on resistance of the fourth drive part 410. The combined resistance value when the fourth adjustment resistor part 42 and the fourth base resistor part 43 are connected in parallel is equal to the characteristic impedance of the transfer path 92. The inverted signal of a signal to be applied to the P-in terminal is applied to the N-in terminal.

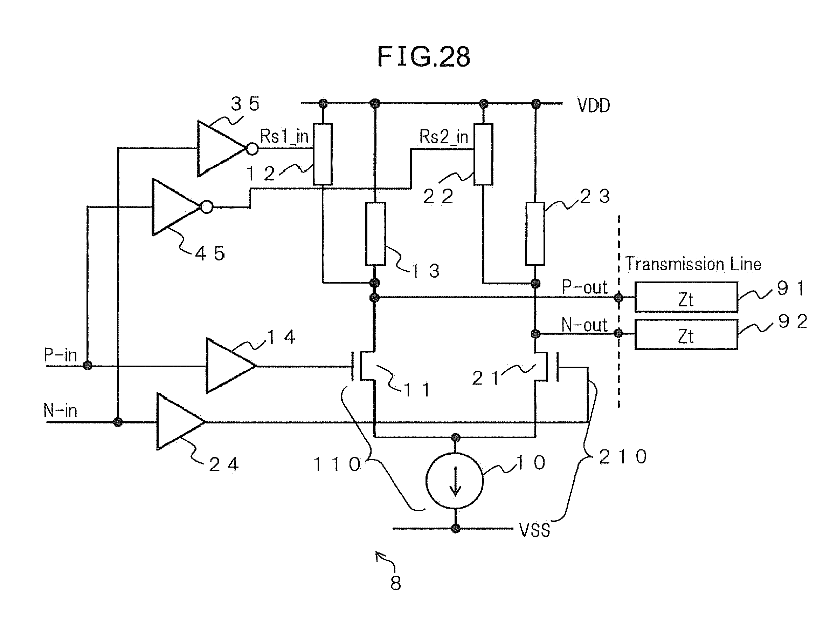

With reference to Fig. 28, an eighth embodiment is explained. Fig. 28 is a diagram illustrating a transmission circuit 8.

The transmission circuit 8 has the first current source 10, the first and second transistors 11 and 21, the first and second adjustment resistor parts 12 and 22, the first and second base resistor parts 13 and 23, the first and third buffers 14 and 15, and first and second inverters 35 and 45.

The transmission circuit 8 differs from the transmission circuit 1 explained previously in that the RS1_in signal to be input to the first adjustment resistor part 12 is not the non-inverted signal of a signal to be input to the P-in terminal but the inverted signal of a signal to be input to the N-in terminal. Further, the transmission circuit 8 differs from the transmission circuit 1 explained previously in that the RS2_in signal to be input to the second adjustment resistor part 22 is not the non-inverted signal of a signal to be input to the N-in terminal but the inverted signal of a signal to be input to the P-in terminal.

The resistance value of the first adjustment resistor part 12 is equal to the on resistance of the first drive part 110. The combined resistance value when the first adjustment resistor part 12 and the first base resistor part 13 are connected in parallel is equal to the characteristic impedance of the transfer path 91. The resistance value of the second adjustment resistor part 22 is equal to the on resistance of the second drive part 210. The combined resistance value when the second adjustment resistor part 22 and the second base resistor part 23 are connected in parallel is equal to the characteristic impedance of the transfer path 92. The inverted signal of a signal to be applied to the P_in terminal is applied to the N_in terminal.

Hereinafter, other embodiments are explained.

In the transmission circuit 1, the first and second termination resistor parts are formed by connecting the first and second adjustment resistor parts 12 and 22 and the first and second base resistor parts 13 and 23 in parallel. Then, in the transmission circuit 1, control is performed so that the output impedance is constant with the first and second adjustment resistor parts 12 and 22 being in the on state or in the off state in accordance with the states of the first and second drive parts 110 and 210. However, it may also be possible to adopt another configuration in which the resistance values of the first and second termination resistor parts are switched in accordance with the states of the first and second drive parts 110 and 210. For example, it may also be possible to form the termination resistor part by connecting a fixed resistor part and a variable resistor part in series. Further, it may also be possible to adopt a configuration in which two fixed resistor parts connected in parallel and having different resistance values are switched in accordance with the states of the first and second drive parts 110 and 210.

In the transmission circuit 2, the resistance value of the first and second variable adjustment resistor parts 16 and 26 and the resistance value of the first and second variable base resistor parts 17 and 27 can be adjusted, respectively, however, it may also be possible to make only one of the resistance values adjustable. Further, the resistance values of the first and second variable adjustment resistor parts 16 and 26 and the first and second variable base resistor parts 17 and 27 are adjusted by a 4-bit control signal, respectively, however, it may also be possible to make the resistance values so as to be adjusted by a 3- or less-bit control signal or by a 5- or more-bit control signal in accordance with precision of adjustment.

In the transmission circuit 3, the resistance value of the third and fourth variable adjustment resistor parts 18 and 28 and the resistance value of the third and fourth variable base resistor parts 19 and 29 can be set, respectively, however, it may also be possible to make only one of the resistance values one that can be set. Further, the resistance values of the third and fourth variable adjustment resistor parts 18 and 28 and the third and fourth variable base resistor parts 19 and 29 are set by a 4-bit control signal, respectively, however, it may also be possible to form the resistance values so as to be set by a 3- or less-bit control signal or by a 5- or more bit control signal in accordance with precision of setting.

The adjustment resistor parts and the base resistor parts of the transmission circuits 4 to 8 are each a fixed resistor, however, these resistor may be a variable resistor as in the transmission circuit 2. Further, the adjustment resistor parts and the base resistor parts of the transmission circuits 4 to 8 may have a configuration in which they can be set at the time of test of the semiconductor device on which the transmission circuits 4 to 8 are to be mounted as in the transmission circuit 3.

According to the above aspects, a transmission circuit is capable of withholding the reflection at the boundary between a transmitter and a transfer.

All examples and conditional language provided herein are intended for pedagogical purposes of aiding the reader in understanding the invention and the concepts contributed by the inventor to furthering the art, and are to be construed as limitations to such specifically recited examples and conditions, nor does the organization of such examples in the specification relate to a illustrating of the superiority and inferiority of the invention. Although one or more embodiments of the present invention have been described in detail, it should be understood that the various changes, substitutions, and alterations could be made hereto without departing from the spirit and scope of the invention.

## Claims

1. A transmission circuit comprising:

   a first drive part capable of switching to one of an on state that is driven by current and an off state, that is, a high impedance state in accordance the value of a first input signal; and
   a first termination resistor part connected in series with the first drive part and the resistance values of which are switched in accordance with the state of the first drive part.

2. The transmission circuit according to the claim 1, further comprising:

   a second drive part capable of switching to one of an on state that is driven by current and an off state, that is, a high impedance state in accordance the value of a second input signal and configured to enter the off state when the first drive part is in the on state and to enter the on state when the first drive part is in the off state; and
   a second termination resistor part connected in series with the second drive part and the resistance values of which are switched in accordance with the state of the second drive part.

**3.** The transmission circuit according to claim 2, wherein
the first termination resistor part has a first base resistor part and a first adjustment resistor part connected in parallel with the first base resistor part and the resistance values of which are switched in accordance with the state of the first drive part, and
the second termination resistor part has a second base resistor part and a second adjustment resistor part connected in parallel with the second base resistor part and the resistance values of which are switched in accordance with the state of the second drive part.

**4.** The transmission circuit according to claim 3, wherein
the first adjustment resistor part enters the high impedance state when the first drive part is in the on state, and
the second adjustment resistor part enters the high impedance state when the second drive part is in the on state.

**5.** The transmission circuit according to claim 4, wherein
the first adjustment resistor part enters the on state when the first drive part is in the off state and the resistance value of the first adjustment resistor part when in the on state is equal to the on resistance of the first drive part, and
the second adjustment resistor part enters the on state when the second drive part is in the off state and the resistance value of the second adjustment resistor part when in the on state is equal to the on resistance of the second drive part.

**6.** The transmission circuit according to claim 4, wherein
the resistance value of the first adjustment resistor part is alterable and the resistance value of the first adjustment resistor part is adjustable so as to become equal to the on resistance of the first drive part, and
the resistance value of the second adjustment resistor part is alterable and the resistance value of the second adjustment resistor part is adjustable so as to become equal to the on resistance of the second drive part.

**7.** The transmission circuit according to claim 6, wherein
the resistance value of the first base resistor part is alterable and the resistance value of the first base resistor part is adjustable so that the combined resistance value when connected in parallel with the first adjustment resistor part becomes equal to the characteristic impedance of a transfer path, and
the resistance value of the second base resistor part is alterable and the resistance value of the second base resistor part is adjustable so that the combined resistance value when connected in parallel with the second adjustment resistor part becomes equal to the characteristic impedance of the transfer path.

# FIG.1

EP 2 640 023 A1

# FIG.2

INPUT SIGNAL

OUTPUT SIGNAL

OUTPUT IMPEDANCE

P-in

N-in

High

Low

N-out

P-out

High

Low

N-out
SIDE

P-out
SIDE

$Zout(=R_t)$

$Zout(>R_t)$

# FIG.3

EP 2 640 023 A1

FIG.4

# FIG.5

# FIG.6

INPUT SIGNAL

P-in ......................................................... high

N-in ......................................................... low

ADJUSTMENT
RESISTOR PART
CONTROL SIGNAL

Rs1_in ....................................................... ON

Rs2_in ....................................................... OFF

OUTPUT SIGNAL

N-out ........................................................ high

P-out ........................................................ low

OUTPUT IMPEDANCE

P-out/
N-out SIDE ........................................... Zout(=Zt)

FIG.7

# FIG.8

EP 2 640 023 A1

**FIG.9**

EP 2 640 023 A1

# FIG.10

EP 2 640 023 A1

EP 2 640 023 A1

FIG.11A

CNT1[0]  CNT1

CNT1[1]  CNT2

CNT1[2]  CNT3

CNT1[3]  CNT4

SCIN

FIG.11B

FIG.12A

EP 2 640 023 A1

CNT2[0]    CNT1
CNT2[1]    CNT2
CNT2[2]    CNT3
CNT2[3]    CNT4

311
321
322
332
333
346
347
341
342
343
344
345
322
331
334
348
STOUT
17
VDDin

FIG.12B

301    302    VDDin
CNT
303    311
STOUT

# FIG.13

```
                    ┌─────────┐
                    │  START  │
                    └─────────┘
                         │
                         ▼
         ┌──────────────────────────────────┐
S 1 0 1  │ DETERMINE RESISTOR SET VALUE     │
         │ OF ADJUSTMENT RESISTOR           │
         └──────────────────────────────────┘
                         │
                         ▼
         ┌──────────────────────────────────┐
S 1 0 2  │ DETERMINE RESISTOR SET VALUE     │
         │ OF TERMINATION RESISTOR          │
         └──────────────────────────────────┘
                         │
                         ▼
         ┌──────────────────────────────────┐
S 1 0 3  │ TRANSMIT RESISTOR SET VALUE      │
         │ TO EACH DRIVE PART               │
         └──────────────────────────────────┘
                         │
                         ▼
                    ┌─────────┐
                    │   END   │
                    └─────────┘
```

# FIG.14

START

BRING ADJUSTMENT RESISTOR SETTING RESISTOR PART INTO ON STATE — S201

TRANSMIT ADJUSTMENT RESISTOR CONTROL SIGNAL 0000 TO ADJUSTMENT RESISTOR SETTING RESISTOR PART — S202

S203 — IS FIRST TERMINAL VOLTAGE GREATER THAN SECOND TERMINAL VOLTAGE?

YES

NO

S204 — ADD 1 TO ADJUSTMENT RESISTOR CONTROL SIGNAL

INPUT NEW ADJUSTMENT RESISTOR CONTROL SIGNAL TO ADJUSTMENT RESISTOR SETTING RESISTOR PART

S205

S206 — DETERMINE ADJUSTMENT RESISTOR CONTROL SIGNAL AS ADJUSTMENT RESISTOR SET VALUE

END

# FIG.15

START

BRING TERMINATION RESISTOR SETTING
ADJUSTMENT RESISTOR PART INTO ON STATE —S301

INPUT ADJUSTMENT RESISTOR SET
VALUE TO TERMINATION RESISTOR
SETTING ADJUSTMENT RESISTOR PART —S302

INPUT TERMINATION RESISTOR CONTROL
SIGNAL 0000 TO TERMINATION RESISTOR
SETTING RESISTOR PART —S303

S304— IS FIRST
TERMINAL VOLTAGE GREATER
THAN SECOND TERMINAL
VOLTAGE?

YES

NO

S305— ADD 1 TO TERMINATION
RESISTOR CONTROL SIGNAL

INPUT NEW TERMINATION RESISTOR
CONTROL SIGNAL TO TERMINATION
RESISTOR SETTING RESISTOR PART
—S306

S307— DETERMINE TERMINATION
RESISTOR CONTROL SIGNAL
AS TERMINATION RESISTOR
CONTROL SIGNAL

END

# FIG.16

RESISTANCE VALUE SETTING EQUIPMENT 140

RESISTANCE VALUE MEASUREMENT PART 141

RESISTOR SET VALUE SETTING PART 143

RESISTOR SET VALUE DETERMINATION PART 142

130

300

R1OUT
R2OUT
R3OUT
R4OUT
131

RROUT
132

R5OUT
R6OUT
R7OUT
R8OUT
133

CNT3[3:0]
CNT4[3:0]

3

3

3

3

15
Rs1_in
CNT11
18
Rs2_in
CNT21
28
29

25
CNT12
19

P-in
N-in

14
24

11
21

P-out
CNT22
N-out

VDD

10
VSS

EP 2 640 023 A1

FIG.17A

CNT3[0]  CNT1
CNT3[1]  CNT2
CNT3[2]  CNT3
CNT3[3]  CNT4
         SCIN

411
421
422
432
433
434
431
446
447
441
442
443
444
445
448

VDDin

SCOUT

18

FIG.17B

SCIN ── Fuse CELL ── fuse_out ──○| 402

401      CNT

403

VDDin

SCOUT

411

EP 2 640 023 A1

FIG.18A

CNT4[0] ── CNT1

CNT4[1] ── CNT2

CNT4[2] ── CNT3

CNT4[3] ── CNT4

VDDin

SCOUT

18

FIG.18B

VDDin

Fuse CELL ── fuse_out ── 502

VSS

501    CNT

503

SCOUT

511

EP 2 640 023 A1

35

EP 2 640 023 A1

**FIG.19A**

VDDin

4 2 1
4 3 2
4 4 6
4 4 7
4 1 1
4 2 2
4 3 3
4 3 2
4 4 1
4 4 2
4 3 1
4 4 3
4 4 4
4 4 5

CNT1
CNT2
CNT3
4 3 4
CNT4
4 4 8
SCIN

VSS

R1OUT    R2OUT    R3OUT    R4OUT

1 3 1

**FIG.19B**

RROUT

VDD
4 0 5

4 0 4

VSS

1 3 2

FIG.20

# FIG.21

```
                    ┌─────────┐
                    │  START  │
                    └─────────┘
                         │
                         ▼
S401 ┌───────────────────────────────┐
     │   SET RESISTANCE VALUE        │
     │   OF ADJUSTMENT RESISTOR      │
     └───────────────────────────────┘
                         │
                         ▼
S402 ┌───────────────────────────────┐
     │   SET RESISTANCE VALUE OF     │
     │   TERMINATION RESISTOR        │
     └───────────────────────────────┘
                         │
                         ▼
                    ┌─────────┐
                    │   END   │
                    └─────────┘
```

# FIG.22

```
                         ┌─────────┐
                         │  START  │
                         └─────────┘
                              │
                              ▼
S501 ┌────────────────────────────────────────────┐
     │ MEASURE RESISTANCE VALUE OF ADJUSTMENT     │
     │ RESISTOR MEASUREMENT RESISTOR PART         │
     └────────────────────────────────────────────┘
                              │
                              ▼
S502 ┌────────────────────────────────────────────┐
     │ MEASURE RESISTANCE VALUE OF DRIVE PART     │
     │ RESISTOR MEASUREMENT RESISTOR PART         │
     └────────────────────────────────────────────┘
                              │
                              ▼
S503 ┌────────────────────────────────────────────┐
     │    DETERMINE RESISTOR SET VALUE OF         │
     │    VARIABLE ADJUSTMENT RESISTOR PART       │
     └────────────────────────────────────────────┘
                              │
                              ▼
S504 ┌────────────────────────────────────────────┐
     │   SET RESISTOR SET VALUE OF VARIABLE       │
     │   ADJUSTMENT RESISTOR PART                 │
     └────────────────────────────────────────────┘
                              │
                              ▼
                         ┌─────────┐
                         │   END   │
                         └─────────┘
```

# FIG.23

```
START
```

S601 — MEASURE RESISTANCE VALUE OF TERMINATION RESISTOR SETTING RESISTOR

S602 — DETERMINE RESISTOR SET VALUE OF TERMINATION ADJUSTMENT RESISTOR PART

S603 — SET RESISTOR SET VALUE OF TERMINATION ADJUSTMENT RESISTOR PART

```
END
```

# FIG.24

FIG.25

# FIG.26

EP 2 640 023 A1

FIG.27

# FIG.28

EP 2 640 023 A1

| | Europäisches Patentamt European Patent Office Office européen des brevets | **EUROPEAN SEARCH REPORT** | Application Number EP 12 19 9638 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D<br>A | US 2008/136465 A1 (TAKAGI SHINGO [JP])<br>12 June 2008 (2008-06-12)<br>* paragraph [0002] - paragraph [0038];<br>claims 1-20; figures 1, 2 *<br>----- | 1-4<br><br>5-7 | INV.<br>H04L25/02<br>H03K19/0185<br>H03K19/094 |
| X<br>A | US 2009/190648 A1 (SAKANO YOSHIHISA [JP]<br>ET AL) 30 July 2009 (2009-07-30)<br>* abstract;<br>paragraph [0002] - paragraph [0071];<br>figures 1-3 *<br>----- | 1,2<br><br>3-7 | |
| X<br>A | US 2006/049893 A1 (OZASA DAN [JP] ET AL)<br>9 March 2006 (2006-03-09)<br>* abstract;<br>paragraph [0002] - paragraph [0083];<br>figures 1-5 *<br>----- | 1-3<br><br>4-7 | |
| A,D | US 2007/057702 A1 (SUENAGA SHUJI [JP])<br>15 March 2007 (2007-03-15)<br>* paragraph [0002] - paragraph [0084];<br>figures 1, 9 *<br>----- | 1-7 | |
| | | | TECHNICAL FIELDS SEARCHED (IPC)<br>H04L<br>H03K |

The present search report has been drawn up for all claims

| Place of search | Date of completion of the search | Examiner |
|---|---|---|
| The Hague | 18 June 2013 | Papadogiannis, A |

EPO FORM 1503 03.82 (P04C01)

## ANNEX TO THE EUROPEAN SEARCH REPORT
## ON EUROPEAN PATENT APPLICATION NO.

EP 12 19 9638

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2013

| Patent document cited in search report | | Publication date | Patent family member(s) | | Publication date |
|---|---|---|---|---|---|
| US 2008136465 | A1 | 12-06-2008 | JP<br>US | 2008147940 A<br>2008136465 A1 | 26-06-2008<br>12-06-2008 |
| US 2009190648 | A1 | 30-07-2009 | NONE | | |
| US 2006049893 | A1 | 09-03-2006 | NONE | | |
| US 2007057702 | A1 | 15-03-2007 | JP<br>JP<br>US | 4756965 B2<br>2007081608 A<br>2007057702 A1 | 24-08-2011<br>29-03-2007<br>15-03-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008147940 A

- JP 2007081608 A